# EUROPEAN PATENT APPLICATION

(11) **EP 3 539 969 A1**
(43) Date of publication of application: **18.09.2019**
(21) Application number: 18161824.0
(22) Date of filing: 14.03.2018
(51) Int. Cl.: C07F 9/32, C07F 9/53, C08F 2/50, G03F 7/029

(54) **NOVEL PHOTO-INITIATORS AND THEIR APPLICATION**

(71) Applicant: ETH Zurich, 8092 Zurich (CH)
(72) Inventor: GRÜTZMACHER, Hansjörg, 8157 Dielsdorf (CH); BISPINGHOFF, Mark, 8050 Zürich (CH); BEIL, Andreas, 8102 Oberengstringen (CH)

(57) **Abstract**

The present invention relates to novel bisacylphosphinic acids, salts and derivatives thereof as well as their use as photo-initiators with superior water solubility and photo-activity. The invention further encompasses versatile processes for the preparation of the aforementioned compounds.

## Description

The present invention relates to novel bisacylphosphinic acids, salts, and derivatives thereof as well as their use as photo-initiators with superior water solubility and photoactivity. The invention further encompasses versatile processes for the preparation of the aforementioned compounds.

Photo-initiators such mono- and bisacylphosphine oxides, in particular those bearing further functionalized substituents have attracted significant commercial attention since photo-initiators, which are tunable with respect to the wavelength at which photo-induced cleavage occurs or which are linkable to other additives, such as sensitizers, stabilizers or surface active agents in order to avoid migration e.g. in food packaging, are highly desirable.

Further, water solubility has become an increasingly interesting property for photo-initiators in general to cope with soaring demand for environmental friendly production of coatings, adhesives, inks and painting materials e.g. for water-borne UV-inkjet inks and to expand their applicability into interesting new fields such as fabrication of hydrogels for tissue engineering.

It is well known to those skilled in the art, however, that in particular bisacylphosphine oxides are only sparingly soluble in water and thus hardly compatible with water borne formulations. Thus, the preparation of radiation curable formulations containing these photo-initiators is often a tedious process, requiring a long time and/or higher temperatures in order to get an adequate formulation. An exception is the commercial product Irgacure 819 DW which is a dispersion of bis(2,4,6-trimethylbenzoyl)-phenyl phosphine oxide (Irgacure 819) in water stabilized by significant amounts of dispersants. However, the use of high levels of dispersants is not desirable at all.

During the last decade many approaches to overcome these limitations have been published.

WO2014/053455 A1 discloses novel mono- and bisacylphosphine oxides comprising additional functional groups inter alia those increasing water solubility. Such functional groups include quaternary ammonium salts, carboxylic acids and polyether functions and are introduced via addition of electron-poor olefins to mono- and bisacylphosphines or their corresponding salts.

It is known from EP 1 749 513 to modify bisacylphosphine oxides by introduction of further substituents at the aryl moieties to improve water solubility and compatibility with aqueous formulations. However the introduction of such substituents requires a multi-step synthesis which renders this approach not attractive for most applications.

A further option to increase water solubility is to provide acylphosphine oxides carrying one or two hetero atom substituents besides one or two acyl substituents on the central phosphorus atom.

US 4,710,523 discloses the use of monoacylphosphinic alkyl esters oxides as photo-initiators which were prepared via an Arbusov-type reaction of an acyl chloride with a suitable phosphinic acid ester.

Further, polycyclic monoacylphosphinic acid ester derivatives have been disclosed in US 5,096,935. In these structures the aryl ester group is linked to a P-aryl substituent forming a polycyclic system (9,10-dihydro-9-oxa-10-phosphaphenanthrene 10-oxide, DOPO). By alkaline hydrolysis thereof acyl (hydroxybiphenyl) phosphinic acid metal salts are obtained.

Bisacylphosphosphinic acid aryl esters such as bis(2,6-dichlorobenzoyl)-(4-butylphenoxy)-phosphine oxide and their use as photo-initiators are known from US 7,097,456.

Further alkyl and aryl esters of bisacylphosphinic acid are known from WO 2012/012067 A and CN103288873 A, bisacylphosphinic acids and derivatives thereof are known from WO2014095724 A1.

A common feature of all compounds used as photo-initiators and known from the prior art mentioned above is that the aryl substituents bound to the carbonyl functions carry substituents in both the 2- and 6-position, i.e. the ortho positions. This substitution pattern is said to provide steric shielding of the carbonyl group, and thus sufficient chemical stability of the photo-initiator in formulations such as stability against nucleophilic attack in aqueous solutions which would lead to hydrolysis and thus inactivation of the photo-initiator.

CN106554430A discloses acylphosphine photo-initiators bearing an additional tertiary amine functionality in the aroyl groups bound to the central phosphorous atom in order to shift the UV absorption wavelength to 380 nm to 395 nm. The compounds are said to exhibit a good solubility in various kinds of resins and oligomers. Many of the disclosed compounds do not bear any substituents in ortho-position of the aroyl substituents. However, their preparation requires a tedious multistep procedure starting from dihalophosphines which renders their manufacture commercially unattractive. Further due to lack of highly polar or ionic groups their water solubility is poor.

As a consequence, there is still a need for highly photo-active, water soluble photo-initiators.

In one aspect the invention therefore provides and encompasses compounds of formula (I): 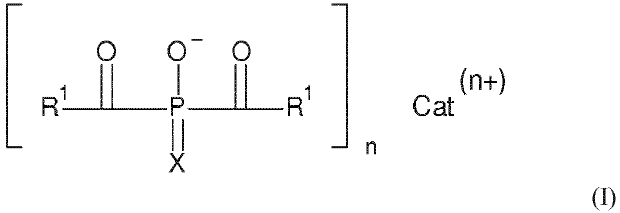 wherein
- **X**: is oxygen or sulfur, preferably oxygen
- **n**: is an integer of 1 or more, preferably 1 to 6, more preferably 1,2 or 3, and even more preferably 1
- **Cat⁽ⁿ⁺⁾**: is an n-valent cation and
- the substituents **R¹**: are independently, preferably identically selected from those of formulae (IIa) and (IIb) 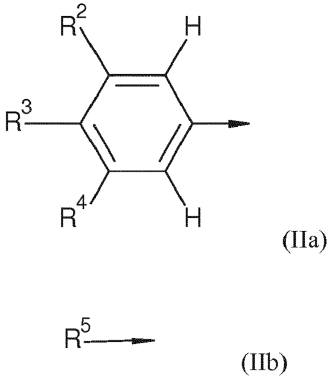
wherein
the arrows indicate the bond to the carbonyl function depicted in formula (I) and in formula (IIa)
- R², R³ and R⁴: are independently selected from the group consisting of hydrogen, halogen, -NO₂, -CN, -SO₂N(R⁶)₂, -NR⁶SO₂R⁷, -(NR⁶)₂, -COR⁷, -O(CO)R⁶, -(CO)OR⁷, -O(CO)OR⁷, -NR⁶(CO)N(R⁶)₂, -NR⁶(CO)R⁷, -(CO)N(R⁶)₂, -NR⁶(CO)OR⁷, -O(CO)N(R⁶)₂, -Si(R⁷)₃, -OSi(R⁷)₃, Si(OR⁷)_{y}(R⁷)_{3-y}, -OSi(OR⁷)_{y}R⁷)_{3-y} with y = 1, 2 or 3, -SO₃M, -COOM, PO₃M₂, -PO(N(R⁶)₂)₂, PO(OR⁷)₂, N(R⁶)₃⁺An⁻, heterocyclyl, alkyl, alkoxy, alkyl-thio, alkenyl, alkenoxy, alkene-thio, aryl, aryloxy, aryl-thio or two substituents together are aryldiyl, alkanediyl or alkenediyl, alkanedioxy, alkaneoxy, alkenedioxy, alkeneoxy
whereby the alkyl, alkoxy, alkyl-thio, alkenyl, alkenoxy, alkene-thio, alkanediyl or alkenediyl, alkanedioxy, alkaneoxy, alkenedioxy, alkeneoxy substituents are
- either not, once, twice or more than twice interrupted by non-successive functional groups selected from the group consisting of: -O-, -S-, -SO₂-, -SO-, -SO₂NR⁶-, -NR⁶SO₂-, -NR⁶-, -CO-, -O(CO)-, (CO)O-, -O(CO)O-, -NR⁶(CO)NR⁶-, -NR⁶(CO)-, -(CO)NR⁶-, -NR⁶(CO)O-, -O(CO)NR⁶-, -Si(R⁷)₂-, -OSi(R⁷)₂-, -OSi(R⁷)₂O-,-Si(R⁷)₂O-,
   and
- either not, once, twice or more than twice interrupted by bivalent residues selected from the group consisting of heterocyclo-diyl, and aryldiyl, and
- either not, once, twice or more than twice substituted by substituents selected from the group consisting of:
   halogen, -CN, C₆-C₁₄-aryl, C₁-C₈-alkoxy, C₁-C₈-alkylthio, -SO₃M,-COOM, PO₃M₂, -PO(N(R⁶)₂)₂, PO(OR⁷)₂, -SO₂N(R⁶)₂, -N(R⁶)₂, -CON(R⁷)₂, -COR⁶, -OCOR⁷, -NR⁶(CO)R⁷, -(CO)OR⁶,-NR⁶(CO)N(R⁶)₂, -Si(OR⁷)_{y}(R⁷)_{3-y}, -OSi(OR⁷)_{y}(R⁷)_{3-y} with y = 1, 2 or 3 and -N(R⁶)₃⁺An⁻, and
in formula (IIb)
- R⁵: is alkyl being
- either not, once, twice or more than twice interrupted by non-successive functional groups selected from the group consisting of: -O-, -S-, -SO₂-, -SO-, -SO₂NR⁶-, -NR⁶SO₂-, -NR⁶-, -CO-, -O(CO)-, -(CO)O-, -O(CO)O-, -NR⁶(CO)NR⁶-, -NR⁶(CO)-, -(CO)NR⁴-, -NR⁴(CO)O-, -O(CO)NR⁶-, -Si(R⁷)₂-, -OSi(R⁷)₂-, -OSi(R⁷)₂O-, -Si(R⁷)₂O-,
   and
- either not, once, twice or more than twice interrupted by bivalent residues selected from the group consisting of heterocyclo-diyl, and aryldiyl,
   and
- either not, once, twice or more than twice substituted by substituents selected from the group consisting of:
   alkyl-thio, aryloxy, halogen, -CN, C₆-C₁₄-aryl, C₁-C₈-alkoxy, C₁-C₈-alkylthio, -SO₃M, -COOM, PO₃M₂, -PO(N(R⁶)₂)₂, PO(OR⁷)₂, -SO₂N(R⁶)₂, -N(R⁶)₂, -CON(R⁷)₂, -COR⁶, -OCOR⁷, -NR⁶(CO)R⁷, -(CO)OR⁶,-NR⁶(CO)N(R⁶)₂, -Si(OR⁷)_{y}(R⁷)_{3-y}, -OSi(OR⁷)_{y}(R⁷)_{3-y} with y = 1, 2 or 3, and also -N(R⁶)₃⁺An⁻
whereby in all formulae where used
R⁶ is independently selected from the group consisting of hydrogen, C₁-C₈-alkyl, C₆-C₁₄-aryl, and heterocyclyl or N(R⁶)₂ as a whole is a N-containing heterocycle,
R⁷ is independently selected from the group consisting of C₁-C₈-alkyl, C₆-C₁₄-aryl, and heterocyclyl or N(R⁶)₂ as a whole is a N-containing heterocycle
M is hydrogen, or 1/q equivalent of an q-valent metal ion or is an ammonium ion or a guanidinium ion or a primary, secondary, tertiary or quaternary organic ammonium ion, in particular those of formula [N(C₁-C₁₈-alkyl)ₛHₜ]⁺ wherein s is 1,2, 3 or 4 and t is (4-s) and
An⁻ is 1/p equivalent of a p-valent anion.

The scope of the invention encompasses all combinations of substituent definitions, parameters and illustrations set forth above and below, either in general or within areas of preference or preferred embodiments, with one another, i.e., also any combinations between the particular areas and areas of preference.

Whenever used herein the terms "including", "e.g.", "such as" and "like" are meant in the sense of "including but without being limited to" or "for example without limitation", respectively.

As used herein, and unless specifically stated otherwise, **aryl** denotes carbocyclic aromatic substituents, whereby said carbocyclic, aromatic substituents are unsubstituted or substituted by up to five identical or different substituents per cycle. For example and with preference, the substituents are selected from the group consisting of fluorine, bromine, chlorine, iodine, nitro, cyano, formyl or protected formyl, hydroxy or protected hydroxy, C₁-C₈-alkyl, C₁-C₈-haloalkyl, C₁-C₈-alkoxy, C₁-C₈-haloalkoxy, C₆-C₁₄-aryl, in particular phenyl and naphthyl, di(C₁-C₈-alkyl)amino, (C₁-C₈-alkyl)amino, CO(C₁-C₈-alkyl), OCO(C₁-C₈-alkyl), NHCO(C₁-C₈-alkyl), N(C₁-C₈-alkyl)CO(C₁-C₈-alkyl), CO(C₆-C₁₄-aryl), OCO(C₆-C₁₄-aryl), NHCO(C₆-C₁₄-aryl), N(C₁-C₈-alkyl)CO(C₆-C₁₄-aryl), COO-(C₁-C₈-alkyl), COO-(C₆-C₁₄-aryl), CON(C₁-C₈-alkyl)₂ or CONH(C₁-C₈-alkyl), CO₂M, CONH₂, SO₂NH₂, SO₂N(C₁-C₈-alkyl)₂, SO₃M and PO₃M₂.

In a preferred embodiment, the carbocyclic, aromatic substituents are unsubstituted or substituted by up to three identical or different substituents per cycle selected from the group consisting of fluorine, chlorine, cyano, C₁-C₈-alkyl, C₁-C₈-haloalkyl, C₁-C₈-alkoxy, C₁-C₈-haloalkoxy, C₆-C₁₄-aryl, in particular phenyl.

In a more preferred embodiment the carbocyclic, aromatic substituents are unsubstituted or substituted by up to three identical or different substituents per cycle selected from the group consisting of fluorine, C₁-C₈-alkyl, C₁-C₈-fluoroalkyl, C₁-C₈-alkoxy, C₁-C₈-fluoroalkoxy, and phenyl, which are in an even more preferred embodiment not positioned in the ortho-positions.

The definitions given above, including their areas of preference, also apply analogously to **aryloxy, aryl-thio, aryldiyl** and **aryl-n-yl** substituents. Preferred aryl substituents are C₆-C₁₄-aryl substituents, more preferably phenyl, naphthyl, phenanthrenyl and anthracenyl. The term C₆-C₁₄ indicates that the number of carbon atoms of the respective carbocyclic, aromatic ring system is from 6 to 14. The possible and preferred substitution patterns mentioned above are likewise applicable.

As used herein and unless specifically stated otherwise, **heterocyclyl** denotes heterocyclic aliphatic, aromatic or mixed aliphatic and aromatic substituents in which no, one, two or three skeleton atoms per cycle, but at least one skeleton atom in the entire cyclic system is a heteroatom selected from the group consisting of phosphorous, nitrogen, sulphur and oxygen, preferably nitrogen, sulphur and oxygen, whereby such heterocyclic aliphatic, aromatic or mixed aliphatic and aromatic substituents are unsubstituted or substituted by up to the possible limit identical or different substituents per cycle, whereby the substituents are selected from the same group as given above for carbocyclic aromatic substituents including the areas of preference.

Preferred heterocyclyl-substituents and heteroaryl-substituents respectively are pyridinyl, oxazolyl, thiophenyl, benzofuranyl, benzothiophenyl, dibenzofuranyl, dibenzothiophenyl, furanyl, indolyl, pyridazinyl, pyrazinyl, imidazolyl, pyrimidinyl and quinolinyl, either unsubstituted or substituted with one, two or three substituents selected from the group consisting of hydroxy, protected hydroxy, chloro, fluorine, C₁-C₈-alkyl, C₁-C₈-fluoroalkyl, C₁-C₈-alkoxy, C₁-C₈-fluoroalkoxy, and phenyl. One skilled in the art is aware that e.g. heteroaryl-substituents bearing a hydroxyl group adjacent to e.g. nitrogen are typically depicted or denoted as keto compounds (e.g. pyridone for 2-hydroxypyridine). These tautomeric forms shall be encompassed by above definition as well.

The definitions given above, including their areas of preference, also apply analogously to **heterocyclylium** and **heteroarylium** cations and the bivalent **heterocyclo-diyl** and **heteroaryldiyl** substituents.

Preferred **heterocyclylium** cations are N-(C₁-C₈-alkyl)imidazolium or pyridinium cations.

As used herein, and unless specifically stated otherwise, **protected formyl** is a formyl substituent which is protected by conversion to an aminal, acetal or a mixed aminal acetal, whereby the aminals, acetals and mixed aminal acetals are either acyclic or cyclic.

For example, and with preference, protected formyl is 1,1-(2,4-dioxycyclopentanediyl).

As used herein, and unless specifically stated otherwise, **protected hydroxy** is a hydroxy radical which is protected by conversion to a ketal, acetal or a mixed aminal acetal, whereby the aminals, acetals and mixed aminal acetals are either acyclic or cyclic. A specific example of protected hydroxyl is tetrahydropyranyl (O-THP).

As used herein, and unless specifically stated otherwise, **alkyl, alkanediyl, alkenyl, alkenediyl, alkynyl, alkane-n-yl** and **alkene-n-yl, alkoxy, alkenoxy, alkyl-thio, alkanedioxy, alkenedioxy** and **alkeneoxy** are straight-chained, cyclic either in part or as a whole, branched or unbranched.

The term **C₁-C₁₈-alkyl** indicates that the straight-chained, cyclic either in part or as a whole, branched or unbranched alkyl substituent contains from 1 to 18 carbon atoms excluding the carbon atoms of optionally present substituents to the C₁-C₁₈-alkyl substituent. The same analogously applies to **alkyl, alkanediyl, alkenyl, alkenediyl, alkynyl, alkane-n-yl** and **alkene-n-yl, alkoxy, alkenoxy, alkyl-thio, alkanedioxy, alkenedioxy** and **alkeneoxy** having an indicated number of carbon atoms and further substituents having an indicated number of carbon atoms.

For the avoidance of doubt the term alkenyl denotes a substituent comprising at least one carbon-carbon double bond but also more than one double bond, irrespective of its or their location within the straight-chained, cyclic either in part or as a whole, branched or unbranched substituent.

For the avoidance of doubt the term alkynyl denotes a substituent comprising at least one carbon-carbon triple bond but also more than one double bond, irrespective of its or their location within the straight-chained, cyclic either in part or as a whole, branched or unbranched substituent.

Specific examples of C₁-C₄-alkyl are methyl, ethyl, n-propyl, isopropyl, n-butyl, tert-butyl. Additional examples for C₁-C₈-alkyl are n-pentyl, isopentyl, cyclohexyl, n-hexyl, n-heptyl, n-octyl, isooctyl. Additional examples for C₁-C₁₈-alkyl are norbornyl, adamantyl, n-decyl, n-dodecyl, n-hexadecyl, n-octadecyl.

Specific examples of C₁-C₈-alkanediyl-substituents are methylene, 1,1-ethylene, 1,2-ethylene, 1,1-propylene, 1,2-propylene, 1,3-propylene, 1,1-butylene, 1,2-butylene, 2,3-butylene and 1,4-butylene, 1,5-pentylene, 1,6-hexylene, 1,1-cyclohexylene, 1,4-cyclohexylene, 1,2-cyclohexylene and 1,8-octylene.

Specific examples of C₁-C₄-alkoxy-substituents are methoxy, ethoxy, isopropoxy, n-propoxy, n-butoxy and tert-butoxy. An additional example for C₁-C₈-alkoxy is cyclohexyloxy.

Specific examples of C₂-C₁₈-alkenyl and C₂-C₈-alkenyl-substituents include vinyl, allyl, 3-propenyl and buten-2-yl.

Specific examples of C₂-C₁₈-alkynyl and C₂-C₈-alkynyl-substituents include ethinyl-

As used hereinabove, **C₁-C₈-haloalkyl** and **C₁-C₈-haloalkoxy** are **C₁-C₈-alkyl** and **C₁-C₈**-**alkoxy** substituents which are once, more than once or fully substituted by halogen atoms. Substituents which are partially or fully substituted by fluorine are referred to as **C₁-C₈**-**fluoroalkyl** and **C₁-C₈-fluoroalkoxy,** respectively.

Specific examples of C₁-C₈-haloalkyl-substituents are fluoromethyl, difluoromethyl, trifluoromethyl, 2,2,2-trifluoroethyl, chloromethyl, fluoromethyl, bromomethyl, 2-bromoethyl, 2-chloroethyl, nonafluorobutyl and n-perfluorooctyl.

In a preferred embodiment in formula (I):
- **n**: is 1 and
- **Cat⁽ⁿ⁺⁾**: is selected from the group consisting of hydrogen, lithium, sodium, potassium, ammonium, guanidinium, a primary, secondary, tertiary or quarternary ammonium ion, in particular those of formula [N(C₁-C₁₈-alkyl)ₛHₜ]⁺ wherein s is 1, 2, 3 or 4 and t is (4-s), guanidinium that is once, twice three times or four times N-substituted with s (C₁-C₁₈-alkyl) or heterocyclylium.

In a more preferred embodiment in formula (I):
- **n**: is 1 and
- **Cat⁽ⁿ⁺⁾**: is selected from the group consisting of hydrogen, lithium, sodium, potassium, ammonium, guanidinium, quarternary ammonium of formula [N(C₁-C₄-alkyl)ₛHₜ]⁺ wherein s is 1, 2, 3 or 4 and t is (4-s), guanidinium that is once, twice three times or four times N-substituted with s (C₁-C₄-alkyl) or heterocyclylium.

In an even more preferred embodiment in formula (I):
- **n**: is 1 and
- **Cat⁽ⁿ⁺⁾**: is selected from the group consisting of hydrogen, lithium, sodium, potassium, quarternary ammonium of formula [N(C₁-C₄-alkyl)₄]⁺ and tetramethyl-guanidinium or di-N(C₁-C₈-alkyl)-imidazolium.

In one embodiment in formula (I) the substituents **R¹** are those of formula (IIb).

Preferred substituents R⁵ are selected from the group consisting of C₁-C₁₈-alkyl which is
- either not, once, twice or more than twice interrupted by non-successive functional groups selected from the group consisting of:
   -O-, -O(C=O)-, -(C=O)-
   and are
- either not, once, twice or more than twice substituted by substituents selected from the group consisting of:
   fluoro, chloro, phenyl

More preferred substituents R⁵ are selected from the group consisting of C₁-C₆-alkyl which is
- either not, once, twice or more than twice interrupted by non-successive functional groups selected from the group consisting of:
   -O-,
   and are
- not further substituted.

Examples of substituents of formula (IIb) include tert-butyl, isopropyl, cyclohexyl, cyclopentyl, 3,3dimethylbutyl, neopentyl and 2-ethylhexyl

In another, more preferred embodiment, in formula (I) the substituents **R¹** are those of formula (IIa).

Preferred substituents R², R³ and R⁴ substituents of formula (IIa) are selected from the group consisting of hydrogen, fluoro, chloro, bromo, -NO₂, -CN, -SO₂N(R⁶)₂, -(NR⁶)₂, - (CO)OR⁷, -(CO)N(R⁶)₂, -NR⁶(CO)R⁷, alkyl, alkynyl and alkoxy
whereby the alkyl and alkoxy substituents are
- either not, once, twice or more than twice interrupted by non-successive functional groups selected from the group consisting of:
   -O-, -O(C=O)-, -(C=O)-
   and are
- either not, once, twice or more than twice substituted by substituents selected from the group consisting of:
   fluoro, chloro, -CN and phenyl
   whereby in all formulae where used
   - R⁶: is independently selected from the group consisting of hydrogen, C₁-C₄-alkyl, phenyl
   - R⁷: is independently selected from the group consisting of C₁-C₄-alkyl or phenyl.

In one preferred embodiment for substituents **R¹** at least one of R², R³ and R⁴ is hydrogen, preferably at least R² and R⁴.

More preferred substituents R², R³ and R⁴ substituents of formula (IIa) are selected from the group consisting of hydrogen, fluoro, chloro, bromo, -NO₂, -CN, -(CO)OR⁷, -(CO)N(R⁶)₂, alkyl and alkoxy
whereby the alkyl and alkoxy substituents are
- either not, once, twice or more than twice interrupted by non-successive functional groups selected from the group consisting of:
   -O-, -O(C=O)-, -(C=O)-
   and are
- either not, once, twice or more than twice substituted by substituents selected from the group consisting of:
   fluoro, chloro, -CN and phenyl
   whereby in all formulae where used
   - R⁶: is independently selected from the group consisting of hydrogen, C₁-C₄-alkyl, phenyl
   - R⁷: is independently selected from the group consisting of C₁-C₄-alkyl or phenyl.

In one preferred embodiment for substituents **R¹** at least one of R², R³ and R⁴ is hydrogen, preferably at least R² and R⁴.

Examples of substituents of formula (IIa) include phenyl, p-tert-butylphenyl, 3-cyanophenyl, 4-cyanophenyl, 3-ethinylphenyl, 4-ethinylphenyl, 4-methylphenyl, 3-methylphenyl, 3,5-dimethylphenyl, 4-methoxyphenyl, 3-methoxyphenyl, p-chlorophenyl, 3,4-dichlorophenyl, 4-bromophenyl, 3-bromophenyl, 3,4-dibromophenyl, 4-nitrophenyl, 3-nitrophenyl, p-trifluoromethyl, p-ethoxycarbonyl-phenyl, p-methoxycarbonylphenyl and p-isopropylphenyl, whereby phenyl is even more preferred.

Specific compounds of formula (I) include:
Bis(benzoyl)phosphinic acid, bis(4-isopropylbenzoyl)phosphinic acid, bis(4-isopropylbenzoyl)phosphinic acid tetra-(n-butyl) ammonium salt, bis(benzoyl)phosphinic acid tetra-(n-butyl) ammonium salt, bis(4-isopropylbenzoyl)phosphinic acid 1,1,3,3-tetra-*N*-methyl-guanidinium salt and bis(benzoyl)phosphinic acid 1,1,3,3-tetra- *N*-methyl-guanidinium salt, bis(benzoyl)phosphinic acid lithium salt, bis(benzoyl)phosphinic acid sodium salt, bis(benzoyl)phosphinic acid potassium salt, bis(benzoyl)phosphinic acid rubidium salt, bis(4-isopropylbenzoyl)phosphinic acid lithium salt, bis(4-isopropylbenzoyl)phosphinic acid sodium salt, bis(4-isopropylbenzoyl)phosphinic acid potassium salt, bis(4-isopropylbenzoyl)phosphinic acid rubidium salt, bis(pivaloyl)phosphinic acid, bis(pivaloyl)phosphinic acid lithium salt, bis(pivaloyl)phosphinic acid sodium salt, bis(pivaloyl)phosphinic acid potassium salt and bis(pivaloyl)phosphinic acid rubidium salt.

The following preparation methods for compounds of formula (I) are also encompassed by the invention:

### Preparation method 1

Compounds of formula (I) may be prepared in any manner known per se for example by the steps of:
A) contacting elemental phosphorous with a alkali or alkaline earth metal optionally in the presence of a catalyst or an activator in a solvent to obtain metal phosphides Met₃P, wherein Met is an alkali or ½ equivalent of an alkaline earth metal, whereby the phosphides are usually present in a polymeric form and are therefore occasionally referred to as polyphosphides
B) optionally adding a proton source, optionally in the presence of a catalyst or an activator to obtain metal dihydrogen phosphides MetPH₂ which may depending on the proton source exist as complexes;
C) reacting said dihydrogen phosphides with two equivalents of compounds selected from those of formula (III) 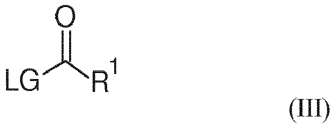 to obtain compounds of formulae (IVa) or ((IVb) 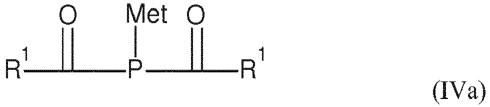 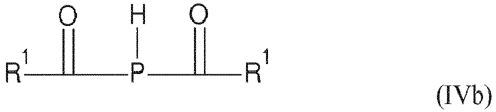 and
D) oxidizing compounds of formula (IVa) or (IVb) to compounds of formula (I) whereby in formulae (III), (IVa), and (IVb)
   R¹ has the same meaning given above for formula (I) above and
   LG denotes a leaving group, preferably chloro, bromo or iodo, C₁-C₈-alkylsulfonyloxy or C₁-C₁₈-alkoxy, more preferably chloro or C₁-C₁₈-alkoxy.

In a preferred embodiment in step c) first a compound of formula (III) is added wherein LG denotes C₁-C₁₈-alkoxy and then a compound of formula (III) wherein LG denotes chloro, bromo or iodo.In a modified procedure, in step C) phosphine (PH₃) and at least one alkali metal alkoxide such as lithium C₁-C₁₈-alkoxide, sodium C₁-C₁₈-alkoxide or potassium C₁-C₁₈-alkoxide may be employed as well instead of performing steps A) and B).

Oxidation may be carried out in any manner known to those skilled in the art and includes reaction with molecular oxygen, hydrogen peroxide, sodium hypochlorite, sodium or potassium percarbonates, monoperoxodisulfate or monopersulfate, peracids such as peracetic acid and 3-chloroperbenzoic acid, hydroperoxides such as tert-butylhydroperoxide, permanganates such as potassium permanganate, chromates and dichromates such as potassium dichromate and aqueous solutions of all of the aforementioned.

For the avoidance of doubt, compounds of formulae (IVa) and (IVb) as depicted above shall also encompass their isomers of formulae (IVa2 and (IVb2)) which are typically present and observable in solution and solid state:

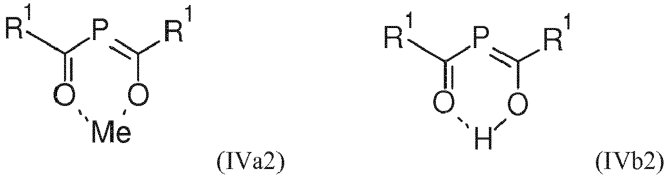

Formulae (IVa) and (IVb) as depicted above shall also encompass dimers, trimers and higher aggregated complexes as well as solvate complexes or other compounds wherein the metal is complexed of the compounds depicted therein.

It is apparent to those skilled in the art, that depending of whether optional step B) is applied or not compounds of formula (IVa) (if step B) is not applied) or (IVb) (if step B) is applied) are predominantly formed.

### Preparation method 2

In an another embodiment compounds of formula (I) may be prepared for example by the steps of:
A) reacting phosphine (PH₃) with compounds (carboxylic acid halides) of formula (V), 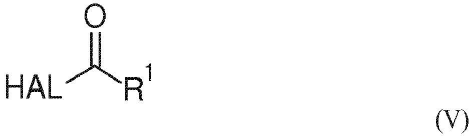 wherein R¹ is as defined above for compounds of formula (I) and
   HAL represents fluoro, chloro, bromo or iodo, preferably chloro or bromo and even more preferably chloro
   whereby the reaction is carried out in the presence of at least one lewis acid to obtain compounds of formula (VI)

   [LAF][P(COR¹)₂]_{q} (VI)

   wherein
   - q: is an integer of 1 to 5, preferably 1, 2 or 3, more preferably 1 or 3
   - LAF: represents hydrogen or a q-valent Lewis Acid Fragment as defined hereinafter, preferably a q-valent Lewis Acid Fragment and
   - R¹: has the same meaning given above for formula (I) above
   and
B) protonating compounds of formula (VI) where LAF represents a Lewis Acid Fragment to obtain compounds of formula (IVb) as defined above and
C) oxidizing compounds of formula (IVb) to obtain compounds of formula (I) as described already for preparation method 1

Specific compounds of formula (V) include benzoylchloride and p-isopropylbenzoylchloride.

It is known to those skilled in the art that compounds of formula (VI) might form oligomers such as dimers or trimers in solution or solid state depending on solvent or other conditions. These oligomers shall be encompassed by formula (VI).

The term "Lewis acid" as used above is understood to mean the generally customary definition of those compounds which have an electron vacancy, as explained, for example, in Römpp's Chemie-Lexikon, 8th edition, Franck'sche Verlagshandlung 1983, Volume 3, H-L.

In a preferred embodiment the at least one Lewis acid is selected from the group including methyl aluminoxane (MAO) and compounds represented by formula (VII)

M^{L}R^{L}₍ᵣ₎X^{L}_{(z-r)} (VII)

wherein
- z: is 2, 3, 4 or 5
- r: is 0 or an integer of at maximum z, preferably 0, 1 or 2, more preferably 0 or 1 and even more preferably 0
- M^{L}: if z is 2 is Sn
if z is 3 is an element selected from the group consisting of Sc, Y, La, Ce, Pr, Nd, Sm, Eu, Gd, Tb, Dy, Ho, Er, Tm, Yb, Lu, Fe, B, Al, Ga, In, As
if z is 4 is an element selected from the group consisting of V, Ti, Zr, Hf, Sn
if z is 5 is an element selected from the group consisting of V, P, As, Sb, Bi
- X^{L}: is independently selected from the group consisting of fluoride, chloride, bromide, iodide, azide, isocyanate, thiocyanate, isothiocyanate or cyanide, preferably fluoro, chloro or bromo, more preferably fluoro or chloro
- R^{L}: represents C₁-C₁₈-alkyl, cyclopentadienyl, C₁-C₁₈-haloalkyl, C₁-C₁₈-alkoxy, C₁-C₁₈-haloalkoxy, C₆-C₁₄-aryl, C₇-C₁₈-arylalkyl, C₆-C₁₄-aryloxy, C₇-C₁₈-arylalkoxy, -O(HC=O), -O(C=O)-(C₁-C₁₈-alkyl), -O(C=O)-(C₆-C₁₄-aryl) and -O(C=O)-(C₇-C₁₈-arylalkyl) or
- two R^{L} together: represent C₄-C₁₈-alkandiyl, C₄-C₁₈-haloalkandiyl, C₄-C₁₈-alkanedioxy, C₄-C₁₈-haloalkanedioxy, C₆-C₁₄-aryldiyl, C₇-C₁₈-arylalkanediyl, C₆-C₁₄-aryldioxy, C₇-C₁₈-arylalkanedioxy, -O(C=O)-(C₁-C₁₈-alkyl)-(C=O)O-, -O(C=O)-(C₆-C₁₄-aryl)-(C=O)O- and -O(C=O)-(C₇-C₁₈-arylalkyl)-(C=O)O-, or oxo (=O)

In one embodiment r is 0.

For this embodiment examples for such compounds include for
- z = 2: tin dichloride
- z = 3: aluminum trichloride, aluminum tribromide, boron trifluoride, boron trichloride, boron tribromide, gallium trichloride, indium trifluoride, scandium trichloride, iron trichloride, arsenic trifluoride, bismuth trichloride.
- z = 4: titanium tetrachloride, titanium tetrabromide, vanadium tetrachloride, tin tetrachloride, zirconium tetrachloride, hafnium tetrachloride titanium bromide trichloride, titanium dibromide dichloride, vanadium bromide trichloride, and tin chloride trifluoride.
- z = 5: antimony pentachloride, antimony pentafluoride, arsenic pentafluoride, antimony chloride pentafluoride and arsenic fluoride tetrachloride

Preferred compounds are aluminum trichloride and boron trifluoride.

Those skilled in the art are aware of the fact that Lewis acids are often supplied or available in form of adducts with weak Lewis bases, in particular ethers. Examples thereof include boron trifluoride diethyletherate or tetrahydrofuranate. Such derivatives shall be encompassed by the mere description of the Lewis acids as well.

In one embodiment r is 1, 2 or 3.

For this embodiment examples for such compounds include for
- z = 3: methyl aluminum dibromide, methyl aluminum dichloride, ethyl aluminum dibromide, ethyl aluminum dichloride, butyl aluminum dibromide, butyl aluminum dichloride, dimethyl aluminum bromide, dimethyl aluminum chloride, diethyl aluminum bromide, diethyl aluminum chloride, dibutyl aluminum bromide, dibutyl aluminum chloride, methyl aluminum sesquibromide, methyl aluminum sesquichloride, ethyl aluminum sesquibromide, ethyl aluminum sesquichloride, methoxyaluminum dichloride, ethoxyaluminum dichloride, 2,6-di-tert-butylphenoxyaluminum dichloride, methoxy methylaluminum chloride, 2,6-di-tert-butylphenoxy methylaluminum chloride, isopropoxygallium dichloride and phenoxy methylindium fluoride, acetoxyaluminum dichloride, benzoyloxyaluminum dibromide, benzoyloxygallium difluoride, methyl acetoxyaluminum chloride, and isopropoyloxyindium trichloride and in one embodiment additionally triphenylboron.
- z = 4: cyclopentadienyltitaniumtrichloride, dicyclopentadienyltitaniumdichloride, cyclopentadienylzirconiumtrichloride and dicyclopentadienylzirconium-dichloride
- z = 5: tetraphenylantimony chloride and triphenylantimony dichloride and vanadium oxytrichloride.

In one embodiment two or more Lewis acids are employed for example two or three.

As a consequence q-valent Lewis Acids Fragments (LAF) are formally cationic structural units formally obtainable by removing q formally anionic substituents from a Lewis acid. It is apparent for those skilled in the art and understood that depending on the Lewis acid employed q is an integer of 1 up to the respective z.

For methylaluminoxane q is at maximum 3.

Preferred Lewis Acids Fragments (LAF) are structural units of formula (VIII)

M^{L}R^{L}₍ᵣᵣ₎X^{L}_{(zz-rr)} (VIII)

wherein
- M^{L}, X^{L} and R^{L}: shall have the same meaning including their areas of preference as described for formula (VII) above
- zz: is (z-q) with q being an integer of 1 up to z, wherein z shall have the same meaning including its areas of preference as described for formula (VII) above and
- rr: is 0 or an integer of at maximum zz, preferably 0, 1 or 2, more preferably 0 or 1 and even more preferably 0.

Preferred Lewis Acid Fragments (LAF) are
for q = 1 (monovalent): dichloroaluminyl AlCl₂ and difluoroboryl BF₂
for q = 2 (divalent): chloroaluminyl AlCl, fluoroboryl BF and zinc
for q = 3 (trivalent): aluminum Al

Those skilled in the art are aware of the fact that the Lewis Acid Fragements (LAF) are formally q-times positively charged and that for example in compounds of formula (VI) the residue P(OCR¹)₂ is formally anionic with the negative charge being delocalized over the five-membered O-C-P-C-O unit.

The process is typically carried out by adding phosphine (PH₃) to a mixture of compound of formula (V) and the at least one Lewis acid either neat or dissolved or suspended in a solvent. Thereby a reaction mixture is formed.

The reaction time is typically in the range of from 2 min to 72 hours, preferably 30 min to 24 hours.

Suitable solvents include and preferably are those which do not or virtually not react under formation of new covalent bonds with phosphine (PH₃), the Lewis acid and the compounds of formula (V).

Such solvents include
- aromatic hydrocarbons and halogenated aromatic hydrocarbons, such as mesitylene, chlorobenzene and dichlorobenzenes,
- amides such as dimethylformamide, dimethylacetamide
- sulfones such as tetraethylensulfone,
- liquid sulfur dioxide and liquid carbon dioxide
- aliphatic hydrocarbons such as pentane, hexane, cyclohexane, methylcyclohexane and
- halogenated aliphatic or olefinic hydrocarbons such as methylchloride, methylenedichloride, chloroform, trichloroethane, tetrachloromethane and tetrachloroethene
and mixtures of the aforementioned solvents.

Preferred solvents are halogenated aliphatic hydrocarbons such as methylchloride, methylenedichloride, chloroform, trichloroethane and tetrachloroethene.

Those skilled in the art are aware that the selection of a suitable solvent depends inter alia from the solubility and reactivity of the Lewis acid(s) employed.

The amount of solvent is not critical at all and is just limited by commercial aspects, since they have to be removed if the compounds of formula (VI) shall finally be isolated.

To facilitate the reaction, mixing energy e.g. by standard agitators stirrers and/or static mixing elements is introduced into the reaction mixture.

Even though not necessary, mixing can also be supported by using high force dispersion devices such as, for example, ultrasound sonotrodes or high pressure homogenizers.

The process may either be performed batch wise or continuously.

A typical and preferred reaction temperature range to carry out the process is from -30°C to 120°C, preferably from -10 to 80°C and even more preferably from 0 to 40°C.

It is evident to those skilled in the art, that where the desired reaction temperature is above the boiling point at 1013 hPa of the solvent employed, the reaction is carried out under sufficient pressure.

The preferred reaction pressure range to carry out the process is from 800 hPa to 10 MPa, preferably from 1000 hPa to 0.5 MPa.

During the reaction compounds of formula (VI) are formed.

The molar ratio of compounds of phosphine (PH₃) to compounds of formula (V) employed in the reaction is typically from 0.4 to 0.9 preferably 0.45 to 0.6.

The molar ratio of compounds of formula (V) and Lewis acid employed in the reaction is typically from 0.01 to 1 mol of Lewis acid per mol of phosphine (PH₃).

The main advantage of the preparation method 2 is that it allows the efficient and high-yielding synthesis of compounds of formula (I) starting from readily available Lewis acids and acid halides which allows a very broad substitution pattern to be applied.

### Preparation method 3

In a another embodiment compounds of formula (I) where X is oxygen may be prepared for example by the steps of:
A) reacting phosphinic acid (H₃PO₂) with compounds (aldehydes) of formula (IX), 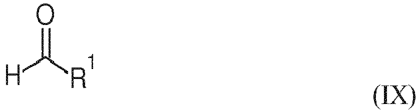 wherein R¹ is as defined above for compounds of formula (I)
   to obtain compounds of formula (X) 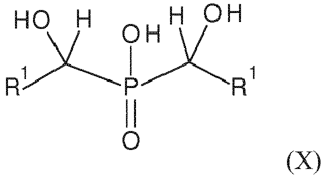 and
B) oxidizing the alcohol functionalities in compounds of formula (X) to obtain compounds of formula (I).

Oxidation of the alcohol functionalities may be carried out in any manner known to those skilled in the art and includes reaction with N-chlorosuccinimide or elemental chlorine in the presence of dialkylsulfides such as dimethylsulfide and an amine such as triethylamine (the Corey-Kim oxidation).

This type of oxidation is disclosed e.g. in E. J. Corey, C. U. Kim, Journal of the American Chemical Society 1972, 94, 7586-7587 and O. Berger, L. Gavara, J.-L. Montchamp, Organic Letters 2012, 14, 3404-3407).

The oxidation can further be carried out
- via the so called Swern oxidation using oxalyl chloride as oxidant, dimethylsulfoxide as catalyst and an amine as a base as disclosed in K. Omura, D. Swern, Tetrahedron 1978, 34, 1651-1660
- via the so called Pfitzner-Moffatt oxidation using dicyclohexylcarbodiimide as oxidant and dimethylsulfoxide as catalyst as disclosed in K. E. Pfitzner, J. G. Moffatt, Journal of the American Chemical Society 1963, 85, 3027-3027
- using hypervalent iodine-reagents like the Dess-Martin periodinane (see D. B. Dess, J. C. Martin, The Journal of Organic Chemistry 1983, 48, 4155-4156)
- via the so called Ley-Griffith oxidation using *N*-methylmorpholin-*N*-oxide as stoichiometric oxidant and tetrapropylammonium perruthenate (TPAP) as catalyst W. P. Griffith, S. V. Ley, G. P. Whitcombe, A. D. White, Journal of the Chemical Society, Chemical Communications 1987, 1625-1627
- via the so called Oppenauer oxidation using acetone and aluminium alcoholatesas disclosed in R. V. Oppenauer, Recueil des Travaux Chimiques des Pays-Bas 1937, 56, 137-144
- using chromium(VI) compounds such as chromiumtrioxide or pyridinium chlorochromate.

The main advantage of the preparation method 3 is that it allows the easy synthesis of compounds of formula (I) starting from cheap phosphinic acid and aldehydes which are available with a broad substitution pattern.

Typically, and depending on the presence or absence of metal salts, compounds of formula (I) are obtained by the three preparation methods outlined above, wherein Cat⁽ⁿ⁺⁾ is hydrogen or a cation already present in or added to the reaction mixture of the final oxidation step.

In order to vary the cation to prepare other compounds of formula (I) all methods known to those skilled in the art to exchange cations may be employed here as well. These methods include ion exchange e.g. with weakly or strongly acidic ion exchangers, adding salts to utilize different solubility of corresponding salt couples or where Cat⁽ⁿ⁺⁾ represents hydrogen simply adding a base comprising the desired cation.

### Advantages

Besides increased solubility in polar solvent systems such as in particular in water compared to those compounds known from prior art, the compounds of formula (I) exhibit unexpected stability again hydrolysis, superior reactivity under blue light irradiation compared to known bisacyl phosphinic acid derivatives and bisacylphosphine oxides bearing substituents at the ortho positions of the aroyl substituents such as mesitoyl substituents.

### Applications

Compounds of formula (I) are particularly useful as photo-initiators.

Therefore one further aspect of the invention relates to photo-curable compositions comprising
I) at least one ethylenically unsaturated compound and
II) at least one compound of formula (I) as defined above.
   Due to their superior water solubility, in one embodiment the photo-curable compositions further comprise
III) water
   Suitable ethylenically unsaturated compounds contain one or more olefinic double bonds and include (meth)acrylic acid esters such as alkyl esters like methyl, ethyl, 2-chloroethyl, N-dimethylaminoethyl, n-butyl, isobutyl, pentyl, hexyl, cyclohexyl, 2-ethylhexyl, octyl, isobornyl esters, phenyl, benzyl and o-, m- and p-hydroxyphenyl esters, hydroxyalkyl esters such as 2-hydroxyethyl, 2-hydroxypropyl, 4-hydroxybutyl, 3,4- dihydroxybutyl or glycerol or [1,2,3-propanetriol] ester, epoxyalkyl esters such as glycidyl, 2,3-epoxybutyl, 3,4-epoxybutyl, 2,3-epoxycyclohexyl, 10,1 1-epoxyundecyl ester, (meth)acrylamides, N-substituted (meth)acrylamides such as N-methylolacrylamide, N- methylolmethacrylamide, N-ethylacrylamide, N-ethylmethacrylamide, N-hexylacryl- amide, N-hexylmethacrylamide, N-cyclohexylacrylamide, N-cyclohexylmethacrylamide, N-hydroxyethylacrylamide, N-phenylacrylamide, N-phenylmethacrylamide, N-benzyl-acrylamide, N-benzylmethacrylamide, N-nitrophenylacrylamide, N-nitrophenylmeth-acrylamide, N-ethyl-N-phenylacrylamide, N-ethyl-N-phenylmethacrylamide, N-(4-hydroxyphenyl)acrylamide and N-(4-hydroxyphenyl)methacrylamide, IBMAA (N-isobutoxymethylacrylamide), (meth)acrylonitriles, unsaturated acid anhydrides such as itaconic anhydride, maleic anhydride, 2,3-dimethylmaleic anhydride, 2-chloromaleic anhydride, unsaturated esters such as maleic acid esters, phthalic acid esters, itaconic acid esters, methylenesuccinic acid esters, styrenes such as methylstyrene, o-, m- or p-chloromethylstyrene and o-, m- and p-hydroxystyrene, divinylbenzene, vinyl ethers such as iso-butyl vinyl ether, ethyl vinyl ether, 2-chloroethyl vinyl ether, hydroxyethyl vinyl ether, propyl vinyl ether, butyl vinyl ether, isobutyl vinyl ether, octyl vinyl ether and phenyl vinyl ether, vinyl and allyl esters such as vinyl acetate, vinyl acrylate, vinyl chloroacetate, vinyl butyrate and vinyl benzoate, divinyl succinate, diallyl phthalate, triallyl phosphate, vinyl chloride and vinylidene chloride, isocyanurates such as triallyl isocyanurate and tris(2-acryloylethyl) isocyanurate, N-vinyl-heterocyclic compounds such as N- vinylpyrrolidones or substituted N-vinylpyrrolidones, N-vinylcaprolactam or substituted N-vinylcaprolactams, N-vinylcarbazole, N-vinylpyridine.

Further examples include diacrylate esters such as 1,6-hexanediol diacrylate (HDDA), ethylene glycol diacrylate, propylene glycol diacrylate, dipropylene glycol diacrylate, tripropylene glycol diacrylate, neopentyl glycol diacrylate, hexamethylene glycol diacrylate and bisphenol A diacrylate, trimethylolpropane triacrylate, trimethylolethane triacrylate, trimethylolpropane trimethacrylate, trimethylolethane trimethacrylate, tetramethylene glycol dimethacrylate, triethylene glycol dimethacrylate, tetraethylene glycol diacrylate, pentaerythritol diacry- late, pentaerythritol triacrylate, pentaerythritol tetraacrylate, dipentaerythritol diacrylate, dipentaerythritol triacrylate, dipentaerythritol tetraacrylate, dipentaerythritol pentaacry- late, dipentaerythritol hexaacrylate, tripentaerythritol octaacrylate, pentaerythritol dimethacrylate, pentaerythritol trimethacrylate, dipentaerythritol dimethacrylate, dipentaerythritol tetramethacrylate, tripentaerythritol octamethacrylate, pentaerythritol diitaconate, dipentaerythritol trisitaconate, dipentaerythritol pentaitaconate, dipentaerythritol hexaitaconate, ethylene glycol diacrylate, 1,3-butanediol diacrylate, 1,3- butanediol dimethacrylate, 1,4-butanediol diitaconate, sorbitol triacrylate, sorbitol tetraacrylate, pentaerythritol-modified triacrylate, sorbitol tetramethacrylate, sorbitol pentaacrylate, sorbitol hexaacrylate, oligoester acrylates and methacrylates, glycerol di- and tri-acrylate, 1,4-cyclohexane diacrylate, bisacrylates and bismethacrylates of polyethylene glycol having molecular weights of from 200 to 2,500, alkoxylated alcohols such glycerol ethoxylate triacrylate, glycerol propoxylate triacrylate, trimethylolpropane ethoxylate triacrylate, trimethylolpropane propoxylate triacrylate, pentaerythritol ethoxylate tetraacrylate, pentaerythritol propoxylate triacrylate, pentaerythritol propoxylate tetraacrylate, neopentyl glycol ethoxylate diacrylate, neopentyl glycol propoxylate diacrylate, unsaturated carboxylic acids such as acrylic acid, methacrylic acid, crotonic acid, cinnamic acid, maleic acid, fumaric acid, itaconic acid, unsaturated fatty acids such as linolenic acid or oleic acid

Further examples for higher-molecular-weight ethylenically unsaturated compounds include esters of ethylenically unsaturated mono- or poly-functional carboxylic acids and polyols or polyepoxides, and polymers having ethylenically unsaturated groups in the main chain or in or as side groups such as, for example, unsaturated polyesters, polyamides and polyurethanes and copolymers thereof, alkyd resins, polybutadiene and butadiene copolymers, polyisoprene and isoprene copolymers, polymers and copolymers having (meth)acrylic groups in side chains, and also mixtures of one or more of such polymers.

Further suitable ethylenically unsaturated compounds include include acrylates which have been modified by reaction with primary or secondary amines, as described, for example, in US3844916, in EP280222, in US5482649 or in US5734002. Such amine-modified acrylates are also termed amine acrylates. Amine acrylates are obtainable, for example, under the name EBECRYL 80, EBECRYL 81 , EBECRYL 83, EBECRYL 7100 from UCB Chemicals, under the name Laromer PO 83F, Laromer PO 84F, Laromer PO 94F from BASF SE, under the name PHOTOMER 4775 F, PHOTOMER 4967 F from Cognis or under the name CN501 , CN503, CN550 from Cray Valley and GENOMER 5275 from Rahn.

Where water is present the at least one ethylenically unsaturated compound may be dissolved or emulsified in water.

In such compositions the concentration of water is for example from 5 to 80 % by weight, preferably from 10 to 60 % by weight.

Further components which may be additionally present in the photo-curable compositions or not are:
- polar diluents or solvents such as ethers like ethylenglycol dimethylether and polyethyleneglycol ethers
- organic or inorganic pigments
- UV-adsorbers
- inorganic fillers
- stabilizers
- isocyanates and/or polyisocyanates
- flattening agents
- matting agents,
- defoamer
- anti-friction agents such as silicon containing antifriction agents,
- surfactants
- resins such as formaldehyde resins, polyurethan resins, polyacrylates, polymethacrylates, polyacrylamides, polymethacrylamides, polyvinylethers, cellulosic resins and sucrose benzoate
- further photoinitiators, including but not limited to Norrish Type I initiators such as 2-hydroxy-1-{4-[4-(2-hydroxy-2-methyl-propionyl)-benzyl]-phenyl}-2-methyl-propan-1-one (Irgacure 127), 2-hydroxy-1-[4-(2-hydroxyethoxy)-phenyl]-phenyl]-2-methylpropan-1-one (Irgacure 2959), 1-hydroxy-cyclohexyl-phenyl-ketone (Irgacure 184), 2-hydroxy-2-methyl-1-phenyl-1-propanone (Irgacure 1173), benzildimethylketal and oligo[2-hydroxy-2-methyl-1-[4-(1-methylvinyl)phenyl]-propanone] (Esacure KIP 150 from Lamberti) as well as mono- or bisacylphosphinoxides.

The amounts of ethylenically unsaturated components, compounds of formula (I), and optional other ingredients will vary according to the type of composition, the particular equipment to be used to apply it and the application.

However, typically, the amount of photo-initiator within the composition is in the range of from 0.05 to 12 wt.-%, preferably 2 to 10 wt.-%, more preferably 4 to 9 wt.-%.

The invention further relates to a process for preparing a cured composition by exposing the photo-curable compositions according to the present invention to electromagnetic radiation, preferably ultraviolet or blue-light radiation.

Suitable sources of electromagnetic radiation include UV lamps like low-pressure, medium-pressure, high-pressure and super-high-pressure mercury lamps which can be undoped or doped e.g. with gallium iodide, thallium iodide or other metal halides; blue, violet-blue LEDs or UV-LEDs; LED lamps, concentrated, direct or indirect sunlight; xenon or xenon mercury arc lamps such as continuous-output xenon short- or long-arc lamps, flash lamps such as xenon or xenon mercury flash lamps; microwave-excited metal vapour lamps; excimer lamps, superactinic fluorescent tubes; fluorescent lamps; and noble gas incandescent lamps.

Preferred sources are lamps like low-pressure, medium-pressure, high-pressure and super-high-pressure mercury lamps which can be undoped or doped e.g. with gallium iodide, thallium iodide or other metal halides; blue, violet-blue or UV-LEDs, xenon or xenon mercury arc lamps such as continuous-output xenon short- or long-arc lamps.

The compositions according to the invention can be used for various purposes, for example in overprint coatings, as printing ink, e.g. screen printing ink, ink for offset- or flexo printing, inkjet ink, ink for sheet-fed printing, electrophotography ink, intaglio ink, as clearcoats, white coats or colour-pigmented coats, e.g. for wood or metal, as powder coatings, as paints, inter alia for paper, wood, metal or plastics, as daylight-curable paints for marking structures and roads, paints for buildings, constructions, vehicles, aircraft, etc., for photographic reproduction processes, for holographic recording materials, for image-recording processes or in the production of printing plates that can be developed using organic solvents or using aqueous-alkaline media, for the production of masks for screen printing, as dental filling compounds, as adhesives, as pressure-sensitive adhesives, as laminating resins, as etch resists or permanent resists, both liquid and dry films, as photostructurable dielectrics, and as solder masks for electronic circuits, as resists in the production of colour filters for any type of display screen or in the creation of structures during the manufacture of plasma displays and electroluminescent displays, in the production of optical switches, optical gratings (interference gratings), in the manufacture of three-dimensional articles by curing in the mass (photo-curing in transparent moulds) or according to the stereolithography process, in the manufacture of composite materials, in the coating or sealing of electronic components or as coatings for optical fibres. The compositions are also suitable for the production of optical lenses, e.g. contact lenses or Fresnel lenses, and also in the manufacture of medical apparatus, aids or implants. The compositions can also be used for the preparation of gels having thermotropic properties.

The compounds of formula (I) are also suitable for use in photo-curable adhesives; e.g. in the preparation of pressure-sensitive adhesives, laminating adhesives, hot-melt adhesives, moisture-cure adhesives, silane reactive adhesives or silane reactive sealants and the like, and related applications. Said adhesives can be hot melt adhesives as well waterborne or solvent borne adhesives, liquid solvent-free adhesives or 2-part reactive adhesives.

The compounds of formula (I) may also be used as free-radical photoinitiators or photoinitiating systems for radiation-curable powder coatings.

As mentioned above, curing according to the invention can be carried out by irradiation with electromagnetic radiation. Depending on the composition of the formulation to be cured, however, thermal curing before, during or after the irradiation may be advantageous.

Thermal curing is carried out by methods known to the person skilled in the art. In general, the curing is carried out in an oven, e.g. a circulating air oven, on a heating plate or by irradiation with IR lamps. Unassisted curing at room temperature is also possible, depending on the binder system used. The curing temperatures are generally between room temperature and 150°C, for example from 25 to 150°C or from 50 to 150°C. In the case of powder coatings or coil coatings, the curing temperatures may be even higher, e.g. up to 350°C.

The advantage of the invention is that the compounds provided based on readily available compounds s starting materials meet the high solubility in photo-curable formulations, especially photo-curable water containing formulations, significantly higher reactivity at desirable wavelengths compared to bisacylphosphine oxide derivatives commercially available today or known so far. It was shown that the compounds of formula (I) can be advantageously used in surfactant free emulsion polymerization.

The invention is hereinafter further explained by the examples without being limited thereto. Some of the experimental results are partially illustrated in figures.
Fig 1 shows UV-Vis spectra measured in tetrahydrofuran (THF) (0.25 mM) prior and after 15 min of 265 nm UV irradiation. The solid line shows bis(benzoyl)phosphinic acid tetrabutylammonium salt (^{Ph}BAPO-ONBu₄) before irradiation, the dashed line ^{Ph}BAPO-ONBu₄ after irradiation, the dotted line bis(mesitoyl)phosphinic acid tetrabutylammonium salt (^{Mes}BAPO-ONBu₄) before irradiation, the dash-dot-dotted line ^{Mes}BAPO-ONBu₄ after irradiation.
Fig 2 shows the ³¹P NMR determination of the photoactivity of ^{Ph}BAPO-ONBu₄ and ^{Mes}BAPO-ONBu₄ via repeatedly irradiating 80 mM samples in CD₃CN in presence of 3 molar equivalents of diphenyl disulfide for 2 min with a 405 nm LED.
Fig. 3 shows the size distribution of polystyrene particles obtained by surfactant free emulsion polymerization using ^{Ph}BAPO-ONBu₄ as photoinitiator.

### Examples:

### I Preparation of compounds of formula (I) an their precursors

### Example 1) Preparation of bis(benzoyl)phosphine (HP(COPh)₂) from elemental phosphorus according to preparation method 1

A suspension of elemental sodium (3.3 eq., 106 mmol, 2.44 g) and red phosphorus (1 eq. 32 mmol, 1.00 g) in dimethoxyethane (DME, 20 mL) was stirred for 3 days at 20 °C. After removing the pieces of excess sodium and cooling the black suspension to 0 °C, *tert-*butanol (1 eq., 32 mmol, 3.1 mL) was added. The suspension was warmed to 20 °C and stirred for 2 hours. Methyl benzoate (1 eq., 32 mmol, 4.0 mL) was added at 0 °C and the red suspension stirred for 1 hour at 20 °C. Subsequently, benzoyl chloride (1 eq., 32 mmol, 3.7 mL) was added at 0 °C and the suspension stirred for another 2 hours at 20 °C before it was treated with concentrated formic acid (3 eq., 96 mmol, 3.6 mL). The orange suspension was filtered through a G3 glass frit, washed with THF (3x 20 mL) and the solvent was removed under reduced pressure. The residue was washed with *n*-hexane (5x 5 mL) and dried under reduced pressure, yielding bis(benzoyl)phosphine as a bright orange powder (5.75 g, 23.7 mmol, 74%).
**¹H-NMR** (300 MHz, C₆D₆): δ/ppm = 20.1 (d, ³*J*_{PH} = 3.1 Hz, O*H*O), 8.20 - 8.10 (m, 4H, *Ar*), 7.12 - 6.95 (m, 6H, *Ar*). **¹³C{¹H}-NMR** (75 MHz, C₆D₆): δ/ppm = 228.3 (d, ¹*J*_{PC} = 86.1 Hz, *C*(O)P), 140.1 (d, ²*J*_{PC} = 26.7 Hz, *Cᵢₚₛₒ*), 144.0 (d, ⁵*J*_{PC} = 2.8 Hz, *Cₚₐᵣₐ*), 128.9 (s, *Cₘₑₜₐ*), 126.5 (d, ³*J*_{PC} = 16.7 Hz, *Cₒᵣₜₕₒ*)*.* **³¹P-NMR** (C6D6, 121 MHz): δ/ppm = 60.1 (s, *enol*).

### Example 2): Preparation of bis(benzoyl)phosphine (HP(COPh)₂) from PH₃ according to preparation method 1 (alternative method)

A 250 mL round bottom flask with two Normag spindle valves was charged with methyl benzoate (1 eq., 200 mmol, 25.2 mL), sodium *tert*-butoxide (1.02 eq., 204 mmol, 19.6 g) and THF (150 mL). One side of the flask was connected to a PH₃ gas bottle and the other side to a series of three bleach bathes. The system was purged with argon for 15 min to remove traces of oxygen. Then it was pressurized with 80 kPa PH₃ under vigorous stirring for 24 hours. The system was opened to the bleach baths and purged with argon for 60 min. Subsequently, benzoyl chloride was added in small portions at 0 °C until full conversion of the mono- to the bis(benzoyl)phosphide was observed by ³¹P-NMR spectroscopy (0.74 eq., 148 mmol, 17.0 mL). The bright red thick solution was stirred for 1 hour at 20 °C and then treated with formic acid (2.0 eq, 400 mmol, 15.0 mL). After stirring for 1 hour at 20 °C, the solvent was removed under reduced pressure, the bright orange residue dissolved in toluene (200 mL) and filtered through a G4 glass frit. The filtrate was concentrated under reduced pressure to about 25 % of its original volume and cooled -30 °C. Bright orange crystals formed, which were collected by filtration, washed with *n*-hexane (3x 20 mL) and dried under reduced pressure. Additional product was isolated by repeated concentration and cooling of the filtrate. Combined yield: 26.7 g, 110 mmol, 55 %.
**¹H-NMR** (300 MHz, C₆D₆): δ/ppm = 20.1 (d, ³*J*_{PH} = 3.1 Hz, O*H*O), 8.20 - 8.10 (m, 4H, *Ar*), 7.12 - 6.95 (m, 6H, *Ar*). **¹³C{¹H}-NMR** (75 MHz, C₆D₆): δ/ppm = 228.3 (d, ¹*J*_{PC} = 86.1 Hz, *C*(O)P), 140.1 (d, ²*J*_{PC} = 26.7 Hz, *Cᵢₚₛₒ*), 144.0 (d, ⁵*J*_{PC} = 2.8 Hz, *Cₚₐᵣₐ*), 128.9 (s, *Cₘₑₜₐ*), 126.5 (d, ³*J*_{PC} = 16.7 Hz, *Cₒᵣₜₕₒ*)*.* **³¹P-NMR** (C6D6, 121 MHz): δ/ppm = 60.1 (s, *enol*).

### Example 3): Preparation of aluminum tris[bis(benzoyl)phosphide][Al(^{Ph}BAP)₃] from PH₃ according to preparation method 2

A 100 mL round bottom flask with two Normag spindle valves was charged with benzoylchloride (PhCOCl, 6 eq., 17.4 mmol, 2.00 mL), AlCl₃ (1 eq., 2.90 mmol, 290 mg) and tetrachloroethene C₂Cl₄ (10 mL). One side of the flask was connected to a PH₃ gas bottle and the other side to a series of three bleach bathes. The system was purged with argon for 15 min to remove traces of oxygen. Then it was pressurized with 80 kPa PH₃ under vigorous stirring. An incipient pressure drop was followed by a pressure rise to about 120 kPa due to the formation of HCl as by-product. The system was opened to the bleach bath and pressurized with PH₃ again. This procedure was repeated several times until the pressure remained stable. The orange suspension was stirred for another 16 h under 80 kPa PH₃ pressure, before it was opened to the bleach bath and purged with argon for 60 min. The suspension was transferred to a 100 mL round bottom Schlenk flask and the solvent removed to a minimum under reduced pressure. Precipitation of the product was completed by addition of n-hexane (50 mL). The product was collected on a G3 glass frit, washed with n-hexane (3x 10 mL) and dried under reduced pressure, yielding the aluminum complex [Al(^{Ph}BAP)₃] as a bright red powder (1.35 g, 1.80 mmol, 62%).
**¹H-NMR** (300 MHz, CDCl₃): δ = 8.19 (d, ³*J*_{HH} = 7.8 Hz, 12H, o-Ph-*H*), 7.51 (t, ³*J*_{HH} = 7.4 Hz, 8H, p-Ph-*H*), 7.37 (t, ³*J*_{HH} = 7.7 Hz, 12H, m-Ph-*H*) ppm.
**¹³C{¹H}-NMR** (75 MHz, CDCl₃): δ = 227.7 (d, ¹*J*_{PC} = 88.5 Hz, *C*(O)P), 142_{.}1 (d, ²*J*_{PC} = 32.6 Hz, ipso-*Ph*), 133.6 (s, p-*Ph*), 128.6 (s, m-*Ph*), 127.0 (d, ³*J*_{PC} = 17.0 Hz, o-*Ph*) ppm. **³¹P-NMR** (CDCl₃, 121 MHz): δ = 68.7 (s) ppm.

### Example 4): Preparation of bis(benzoyl)phosphine HP(COPh)₂ from [Al(^{Ph}BAP)₃] according to preparation method 2

A suspension of the aluminum complex [Al(^{Ph}BAP)₃] (1 eq, 0.100 mmol, 75 mg) prepared according to example 3) and citric acid (2 eq., 0.200 mmol, 38 mg) in toluene (2.0 mL) was refluxed for 2.5 hours. The resulting orange suspension was filtered over a G3 glass frit and the solvent of the filtrate removed under reduced pressure, yielding bis(benzoyl)phosphine HP(COPh)₂ as a bright orange powder (70 mg, 0.289 mmol, 96%).
**¹H-NMR** (300 MHz, C₆D₆): δ = 20.1 (d, ³*J*_{PH} = 3.1 Hz, O*H*O), 8.20 - 8.10 (s, 4H, *Ar*), 7.12 - 6.95 (s, 6H, Ar) ppm. **¹³C{¹H}-NMR** (75 MHz, C₆D₆): δ = 228.3 (d, ¹*J*_{PC} = 86.1 Hz, *C*(O)P), 140.1 (d, ²*J*_{PC} = 26.7 Hz, *Cᵢₚₛₒ*), 144.0 (d, ⁵*J*_{PC} = 2.8 Hz, *Cₚₐᵣₐ*), 128.9 (s, *Cₘₑₜₐ*), 126.5 (d, ³*J*_{PC} = 16.7 Hz, *Cₒᵣₜₕₒ*) ppm. **³¹P-NMR** (CDCl₃, 121 MHz): δ = 90.2 (s, *enol*), 3.8 (d, ¹*J*_{PH} = 243.6 Hz, *keto*) ppm.

### Example 5): Oxidation of bis(benzoyl)phosphine HP(COPh)₂ to bis(benzoyl)phosphinic acid tetrabutylammonium salt (^{Ph}BAPO-ONBu₄) with 3-chloroperbenzoic acid according to preparation method 1 or 2

To a suspension of bis(benzoyl)phosphine HP(COPh)₂ (1 eq., 6.20 mmol, 1.50 g) in H₂O (50 mL) was added 3-chloroperbenzoic acid (3 eq., 18.6 mmol, 3.21 g). After stirring the suspension for 3 hours in the dark at 20 °C, the pale yellow solid was removed by filtration. Subsequently, tetrabutylammonium chloride (1.5 eq., 9.3 mmol, 2.58 g) was added and the pale yellow solution stirred for 15 min at 20 °C. The aqueous solution was extracted with dichloromethane DCM (3x 20 mL), the organic layer dried over MgSO₄ and the solvent removed under reduced pressure, yielding ^{Ph}BAPO-ONBu₄ as deep yellow oil (3.19 g, 6.19 mmol, 99%).
**¹H NMR** (400 MHz, CDCl₃, 298 K) δ/ppm = 8.37 (d, *J* = 7.3 Hz, 4H, o-Ph-*H*), 7.49 (t, *J* = 7.3 Hz, 2H, p-Ph-*H*), 7.40 (t, *J* = 7.6 Hz, 4H, m-Ph-*H*), 3.25-3.14 (m, 8H, ⁺N(C*H*₂CH₂CH₂CH₃)₄), 1.62-1.49 (m, 8H, ⁺N(CH₂C*H*₂CH₂CH₃)₄), 1.33 (t, *J* = 7.3 Hz, 8H, ⁺N(CH₂C*H*₂CH₂CH₃)₄), 0.91 (t, *J* = 7.3 Hz, 12H, ⁺N(CH₂CH₂CH₂C*H*₃)₄); **¹³C{¹H} NMR** (100.6 MHz, CDCl₃, 298 K) δ/ppm = 212.0 (d, *J*_{PC} = 112.9 Hz, PCO), 137.4 (d, *J*_{PC} = 44.8 Hz, ipso-Ph), 132.8 (p-Ph), 129.5 (o-Ph), 128.2 (m-Ph), 58.6 (⁺N(*C*H₂CH₂CH₂CH₃)₄), 23.9 (⁺N(CH₂*C*H₂CH₂CH₃)₄), 19.6 (⁺N(CH₂CH₂*C*H₂CH₃)₄), 13.6 (⁺N(CH₂CH₂CH₂*C*H₃)₄); **³¹P NMR** (161.2 MHz, CDCl₃, 298 K) δ/ppm = 5.1 (s); **FT-IR** v/cm⁻¹ = 2961 m, 2874 w, 2328 w, 1706 m, 1646 m, 1594 m, 1580 w, 1487 w, 1448 m, 1381 w, 1313 w, 1216 s, 1174 m, 1106 w, 1068 s, 1027 w, 1000 w, 967 w, 913 m, 882 w, 775 m, 737 w, 715 w, 692 s, 656 w; **UV Vis** (THF) λ/nm = 235, 266 (sh), 394.

### Example 6): Oxidation of bis(benzoyl)phosphine HP(COPh)₂ to bis(benzoyl)phosphinic acid tetrabutylammonium salt (^{Ph}BAPO-ONBu₄) with peracetic acid according to preparation method 1 or 2

A round bottom flask was charged with bis(benzoyl)phosphine HP(COPh)₂ (1 eq., 10 mmol, 2.42 g), tetrabutylammonium chloride (1.5 eq., 15 mmol, 4.17 g),DCM (30 mL) and an acetate buffer solution (pH = 7, 30 mL). Peracetic acid (2.5 eq., 25 mmol, 35 w-%, 4.8 mL) was added slowly over 15 min to the stirring biphasic system at 0 °C. The solution was warmed to 20 °C, the organic layer isolated and the aqueous layer extracted with DCM (3x 10 mL). The combined organic layers were washed with H₂O (5x 50 mL), dried over MgSO₄ and the solvent removed under reduced pressure, yielding ^{Ph}BAPO-ONBu₄ as deep yellow oil (4.66 g, 9.08 mmol, 91 %).
**¹H NMR** (400 MHz, CDCl₃, 298 K) δ/ppm = 8.37 (d, *J* = 7.3 Hz, 4H, o-Ph-*H*), 7.49 (t, *J* = 7.3 Hz, 2H, p-Ph-*H*), 7.40 (t, *J* = 7.6 Hz, 4H, m-Ph-*H*), 3.25-3.14 (m, 8H, ⁺N(C*H*₂CH₂CH₂CH₃)₄), 1.62-1.49 (m, 8H, ⁺N(CH₂*C*H₂cH₂CH₃)₄), 1.33 (t, *J* = 7.3 Hz, 8H, ⁺N(CH₂CH₂C*H*₂CH₃)₄), 0.91 (t, *J* = 7.3 Hz, 12H, ⁺N(CH₂CH₂CH₂C*H*₃)₄); **¹³C{¹H} NMR** (100.6 MHz, CDCl₃, 298 K) δ/ppm = 212.0 (d, *J*_{PC} = 112.9 Hz, PCO), 137.4 (d, *J*_{PC} = 44.8 Hz, ipso-Ph), 132.8 (p-Ph), 129.5 (o-Ph), 128.2 (m-Ph), 58.6 (⁺N(*C*H₂CH₂CH₂CH₃)₄), 23.9 (⁺N(CH₂*C*H₂CH₂CH₃)₄), 19.6 (⁺N(CH₂CH₂*C*H₂CH₃)₄), 13.6 (⁺N(CH₂CH₂CH₂*C*H₃)₄); **³¹P NMR** (161.2 MHz, CDCl₃, 298 K) δ/ppm = 5.1 (s); **FT-IR** v/cm⁻¹ = 2961 m, 2874 w, 2328 w, 1706 m, 1646 m, 1594 m, 1580 w, 1487 w, 1448 m, 1381 w, 1313 w, 1216 s, 1174 m, 1106 w, 1068 s, 1027 w, 1000 w, 967 w, 913 m, 882 w, 775 m, 737 w, 715 w, 692 s, 656 w; **UV Vis** (THF) λ/nm = 235, 266 (sh), 394.

### Example 7): Preparation of bis(hydroxy(4-isopropylphenyl)methyl)phosphinic acid according to preparation method 3

A 100 mL flask equipped with a large magnetic stirring bar was charged with water (30 mL), aqueous phosphinic acid (1 eq., 50 w-%, 22.6 mmol), and cuminaldehyde (2.1 eq., 47.5 mmol, 7.04 g). The reaction mixture was degassed for 30 min by bubbling through an argon stream while stirring. Subsequently, the flask was sealed with a glass stopper and the reaction mixture was stirred (400 rpm) for two days at 100 °C (oil bath temperature). An off-white solid was formed, which was triturated with 100 mL of water. The obtained suspension was filtered through a G4 glass frit and the solid was further washed with water and a minimal amount of toluene (10 mL). After drying the crude product in an air stream, it was dissolved in boiling MeOH under the addition of conc. HCl aq. (0.1 mL). After evaporation *in vacuo,* the white solid was recrystallized from boiling MeOH (→ -25 °C) to obtain bis(hydroxy(4-isopropylphenyl)methyl)phosphinic acid as a colourless solid, which was dried *in vacuo* (5.45 mmol, 1.975 g, 24 %). Evaporating the mother liquor yields a second batch (9.956 mmol, 3.608 g, 44 %).
**¹H NMR** (300 MHz, DMSO-d₆, 298 K) δ/ppm = 7.36 (broad d, *J* = 7.0 Hz, 4H, arom-*H*), 7.20 (broad d, *J* = 8.1 Hz, 4H, arom-*H*), 5.10 (d, *J* = 7.1 Hz, C*H*OH), 2.88 (hept, *J* = 6.8 Hz, 2H, C*H*(CH₃)₂), 1.21 (d, *J* = 6.9 Hz, CH(C*H*₃)₂); **³¹P NMR** (121.5 MHz, DMSO-d₆, 298 K) δ/ppm = 38.6 (bs)

### Example 8): Preparation of bis(4-isopropylbenzoyl)phosphinic acid 1,1,3,3-tetramethylguanidinium salt (^{Cum}BAPO-OTMG) according to preparation method 3

A Schlenk flask was charged with bis(hydroxy(4-isopropylphenyl)methyl)phosphinic acid (1 eq., 4.462 mmol, 1.617 g) and *N*-chlorosuccinimide (2.1 eq., 9.37 mmol, 1.251 g) prepared according to example 5) under inert conditions. After dissolving in dry dichloromethane (150 mL), the reaction mixture was cooled to -78 °C in an aceton/dry ice bath. Dimethyl sulfide (2.1 eq., 9.37 mmol, 0.7 mL) was added and the reaction was stirred at -78 C for 10 min. After adding distilled triethyl amine (3 eq., 13.4 mmol, 1.9 mL), the reaction was warmed to room temperature overnight in the dark yielding a clear yellow solution. The crude reaction mixture was extracted with water (1×100 mL) and brine (2×100 mL). After drying the yellow organic layer over Na₂SO₄, evaporation *in vacuo* yielded a yellow solid, which was dissolved in dichloromethane (DCM). 1,1,3,3-Tetramethylguanidine (0.2 mL) was added and the mixture was evaporated *in vacuo* at elevated temperature. The residue was recrystallized from DCM/hexane at low temperature. Yield not determined.
**¹H NMR** (300 MHz, CDCl₃, 298 K) δ/ppm = 8.19 (d, *J* = 8.2 Hz, 4H, arom-*H*), 7.17 (d, *J* = 8.2 Hz, 4H, arom-*H*), 2.82 (hept, *J* = 7.4 Hz, 2H, C*H*(CH₃)₂), 2.75 (bs, 12H, ⁺NH₂C(N(C*H*₃)₂)₂), 1.15 (d, *J* = 6.9 Hz, CH(C*H*₃)₂); **³¹P NMR** (121.5 MHz, CDCl₃, 298 K) δ/ppm = 5.6 (s).

### Example 9): Preparation of bis(hydroxy(phenyl)methyl)phosphinic acid according to preparation method 3

A 500 mL flask equipped with a large magnetic stirring bar is charged with water (300 mL), aqueous phosphinic acid (1 eq., 50 w-%, 256 mmol, 28 mL, ρ = 1.206 g/cm³, 16.9 g,), and benzaldehyde (2.12 eq., 542 mmol, 57.5 g, ρ = 1.045 g/cm³, 55 mL). The reaction mixture was degassed for 30 min by bubbling through an argon stream while stirring. Subsequently, the flask was sealed with a glass stopper and the reaction mixture was stirred (400 rpm) for five days at 100 °C (oil bath temperature). An off-white solid was formed, which was triturated with 500 mL of water. The obtained suspension was filtered through a G4 glass frit and the solid further washed with water (300 mL) and a minimal amount of toluene (5× 50 mL). After drying the crude product (41.7 g) in an air stream, it was dissolved in boiling MeOH (300 mL) under the addition of conc. HCl aq. (0.5 mL). After evaporation *in vacuo,* the white solid obtained thereby was recrystallised from THF/MeOH (ca. 2/1) and covered with hexane to obtain bis(hydroxy(phenyl)methyl)phosphinic acid as a colourless solid, which is dried *in vacuo* (73.4 mmol, 20.4 g, 29 %). The final product still contained ca. 11 w-% (1.9 eq.) of water as determined by ¹H NMR spectroscopy.
¹**H NMR** (300 MHz, MeOD-d₄, 298 K) δ/ppm = 7.53 (d, *J* = 7.7 Hz, 4H, o-Ph-*H*), 7.36 (t, *J* = 7.3 Hz, 4H, m-Ph-*H*), 7.28 (t, *J* = 6.8 Hz, 2H, p-Ph-*H*), 5.32 (d, *J* = 7.2 Hz, 2H, C*H*OH); **³¹P NMR** (121.5 MHz, MeOD-d₄, 298 K) δ/ppm = 40.1 (bs); **¹H NMR** (400 MHz, THF-d₄₈, 298 K) δ/ppm = 7.52-7.46 (m, 4H, Ph-*H*), 7.30-7.23 (m, 4H, Ph-*H*), 7.22-7.16 (m, 2H, Ph-*H*), 5.10 (d, *J* = 7.7 Hz, 2H, C*H*OH); **³¹P NMR** (162.0 MHz, THF-d₈, 298 K) δ/ppm = 39.7 (bs).

### Example 10): Preparation of bis(benzoyl)phosphinic acid tetrabutylammonium salt (^{Ph}BAPO-ONBu₄) according to preparation method 3

A 1 L Schlenk flask was charged with bis(hydroxy(phenyl)methyl)phosphinic acid obtained according to example 9 (5.00 g, 18.0 mmol, 1 eq.) and *N*-chlorosuccinimide (5.05 g, 37.8 mmol, 2.1 eq.) and purged with argon. After dissolving in dry dichloromethane (600 mL), the reaction mixture was cooled to -78 °C in an aceton/dry ice bath. Dimethyl sulfide (2.8 mL, 37.8 mmol, 2.1 eq.) was added and the reaction was stirred at -78 °C for 10 min. After adding distilled triethylamine (7.5 mL, 54.0 mmol, 3 eq.), the reaction was warmed to r.t. overnight in the dark yielding an orange solution. After addition of tetrabutylammonium chloride (5.00 g, 18.0 mmol, 1.0 eq.), the reaction mixture was extracted with water (3× 250 mL). After drying the organic layer over Na₂SO₄, evaporation *in vacuo* yielded ^{Ph}BAPO-ONBu₄ as deep yellow oil (5.38 g, 10.4 mmol, 58 %).
**¹H NMR** (400 MHz, CDCl₃, 298 K) δ/ppm = 8.37 (d, *J* = 7.3 Hz, 4H, o-Ph-*H*), 7.49 (t, *J* = 7.3 Hz, 2H, p-Ph-*H*), 7.40 (t, *J* = 7.6 Hz, 4H, m-Ph-*H*), 3.25-3.14 (m, 8H, ⁺N(C*H*₂CH₂CH₂CH₃)₄), 1.62-1.49 (m, 8H, ⁺N(CH₂C*H*₂cH₂CH-₃)₄), 1.33 (t, *J =* 7.3 Hz, 8H, ⁺N(CH₂CH₂C*H*₂CH₃)₄), 0.91 (t, *J* = 7.3 Hz, 12H, ⁺N(CH₂CH₂CH₂C*H*₃)₄); **¹³C{¹H} NMR** (100.6 MHz, CDCl₃, 298 K) δ/ppm = 212.0 (d, *J*_{PC} = 112.9 Hz, PCO), 137.4 (d, *J*_{PC} = 44.8 Hz, ipso-Ph), 132.8 (p-Ph), 129.5 (o-Ph), 128.2 (m-Ph), 58.6 (⁺N(*C*H₂CH₂CH₂CH₃)₄), 23.9 (⁺N(CH₂*C*H₂CH₂CH₃)₄), 19.6 (⁺N(CH₂CH₂*C*H₂CH₃)₄), 13.6 (⁺N(CH₂CH₂CH₂*C*H₃)₄); **³¹P NMR** (161.2 MHz, CDCl₃, 298 K) δ/ppm = 5.1 (s); **FT-IR** v/cm⁻¹ = 2961 m, 2874 w, 2328 w, 1706 m, 1646 m, 1594 m, 1580 w, 1487 w, 1448 m, 1381 w, 1313 w, 1216 s, 1174 m, 1106 w, 1068 s, 1027 w, 1000 w, 967 w, 913 m, 882 w, 775 m, 737 w, 715 w, 692 s, 656 w; **UV Vis** (THF) λ/nm = 235, 266 (sh), 394.

### Example 11): Preparation of bis(benzoyl)phosphinic acid 1,1,3,3-tetra-N-methylguanidinium salt ^{ph}BAPO-OTMG according to preparation method 3

A Schlenk flask is charged with bis(hydroxy(phenyl)methyl)phosphinic acid (4.055 g 14.58 mmol, 1 eq.) and N-chlorosuccinimide (4.09 g, 30.62 mmol, 2.1 eq.) and purged with argon. After dissolving in dry dichloromethane (250 mL), the reaction mixture is cooled to -78 °C in an aceton/dry ice bath. Dimethyl sulfide (2.8 mL, 30.62 mmol, 2.1 eq.) is added and the reaction is stirred at -78 °C for 10 min. After adding distilled triethyl amine (6.0 mL, 43.7 mmol, 3 eq.), the reaction is warmed to room temperature overnight in the dark yielding a clear orange solution. The crude reaction mixture is extracted with water (3× 50 mL). After the addition of 1,1,3,3-tetramethylguanidine (1.74 mL, 13.85 mmol, 0.95 eq.), the mixture is once extracted with water (20 mL). After drying the yellow organic layer over Na₂SO₄, evaporation *in vacuo* at 50 °C yields a semi-solid which is dissolved in DCM upon heating. Covering the solution with hexane leads to the formation of large yellow crystals of bis(benzoyl)phosphinic acid 1,1,3,3-tetra-*N-*methylguanidinium salt ^{Ph}BAPO-OTMG suitable for X-ray crystallography (1.76 g, 4.51 mmol, 31 %).
**¹H NMR** (300 MHz, CDCl₃, 298 K) δ/ppm = 8.63 (bs, 2H, C=N*H*₂⁺), 8.25 (d, *J* = 7.4 Hz, 4H, o-Ph-*H*), 7.42 (t, *J* = 6.9 Hz, 2H, p-Ph-*H*), 7.33 (t, *J* = 7.2 Hz, 4H, m-Ph-*H*), 2.77 (s, 12H, C(N(C*H*₃)₂)₂); **¹³C{¹H} NMR** (75.5 MHz, CDCl₃, 298 K) δ/ppm = 211.7 (d, *J*_{PC} = 112.2 Hz, PCO), 162.1 (*C*=NH₂), 137.1 (d, *J*_{PC} = 45.3 Hz, ipso-Ph), 133.2 (p-Ph), 129.4 (o-Ph), 128.4 (m-Ph), 39.7 (C(N(*C*H₃)₂)₂); **³¹P NMR** (121.5 MHz, CDCl₃, 298 K) δ/ppm = 5.15 (s); **FT-IR** v/cm⁻¹ = 3019 w, 1699 w, 1645 m, 1626 w, 1591 m, 1577 w, 1447 m, 1407 m, 1309 w, 1232 s, 1217 w, 1171 m, 1096 w, 1071 w, 1061 s, 1036 w, 1000 w, 938 w, 916 m, 879 w, 777 m, 723 m, 694 s, 664 w, 616 w.

### Example 12): Preparation of bis(benzoyl)phosphinic acid 1,1,3,3-tetra-N-methylguanidinium salt (^{Ph}BAPO-OTMG) according to preparation method 3

A Schlenk flask is charged with bis(hydroxyl(phenyl)methyl)phosphinic acid (4.055 g 14.58 mmol, 1 eq.) and N-chlorosuccinimide (4.09 g, 30.62 mmol, 2.1 eq.) and purged with argon. After dissolving in dry dichloromethane (250 mL), the reaction mixture is cooled to -78 °C in an acetone/dry ice bath. Dimethyl sulfide (2.8 mL, 30.62 mmol, 2.1 eq.) is added and the reaction is stirred at -78 °C for 10 min. After adding distilled triethyl amine (6.0 mL, 43.7 mmol, 3 eq.), the reaction is warmed to room temperature overnight in the dark yielding a clear orange solution. The crude reaction mixture is extracted with water (3× 50 mL). After the addition of 1,1,3,3-tetramethylguanidine (1.74 mL, 13.85 mmol, 0.95 eq.), the mixture is once extracted with water (20 mL). After drying the yellow organic layer over Na₂SO₄, evaporation *in vacuo* at 50 °C yields a semi-solid which is dissolved in DCM upon heating. Covering the solution with hexane leads to the formation of large yellow crystals of TMG[^{Ph}BAPO-O]_which were suitable for X-ray crystallography confirming the structure (1.76 g, 4.51 mmol, 31 %).
**¹H NMR** (300 MHz, CDCl₃, 298 K) δ/ppm = 8.63 (bs, 2H, C=N*H*₂⁺), 8.25 (d, *J* = 7.4 Hz, 4H, o-Ph-*H*), 7.42 (t, *J* = 6.9 Hz, 2H, p-Ph-*H*), 7.33 (t, *J* = 7.2 Hz, 4H, m-Ph-*H*), 2.77 (s, 12H, C(N(C*H*₃)₂)₂); **¹³C{1H} NMR** (75.5 MHz, CDCl₃, 298 K) δ/ppm = 211.7 (d, *J*_{PC} = 112.2 Hz, PCO), 162.1 (*C*=NH₂), 137.1 (d, *J*_{PC} = 45.3 Hz, ipso-Ph), 133.2 (p-Ph), 129.4 (o-Ph), 128.4 (m-Ph), 39.7 (C(N(*C*H₃)₂)₂); **³¹P NMR** (121.5 MHz, CDCl₃, 298 K) δ/ppm = 5.15 (s)

### For comparison: Example 13): Preparation of bis(mesitoyl)phosphinic acid tetrabutylammonium salt (^{Mes}BAPO-ONBu₄)

Bismesitoylphosphinic acid (synthesised as described in patent application WO2014095724 A1, 540 mg, 1.5 mmol) and NaHCO₃ (150 mg, 1.8 mmol, 1.2 eq.) were mixed with EtOH (30 mL) and treated in an ultrasonic bath for 1 h. After evaporation *in vacuo*, the residue was suspended in dichloromethane (DCM, 50 mL) followed by the addition of tetra-*n*-butylammonium chloride (417 mg, 1.5 mmol, 1.0 eq.) and another 15 min of ultrasound treatment. The organic phase was twice extracted with water (50 mL), dried over Na₂SO₄ and evaporated *in vacuo* to yield bismesitoylphosphinic acid tetrabutylammonium salt as off-white solid (723 mg, 1.21 mmol, 80 %).
**¹H NMR** (500 MHz, CDCl₃, 298 K) δ/ppm = 6.75 (s, 4H, Mes-*H*), 3.21-3.08 (m, 8H, N(C*H*₂CH₂CH₂CH₃)₄), 2.35 (s, 12H, o-Mes-C*H*₃), 2.25 (s, 6H, p-Mes-C*H*₃), 1.56-1.46 (m, 8H, N(CH₂C*H*₂CH₂CH₃)₄), 1.39-1.28 (m, 8H, N(CH₂CH₂C*H*₂CH₃)₄), 0.95 (t, *J* = 7.3 Hz, 12H, N(CH₂CH₂CH₂C*H*₃)₄); **³¹P NMR** (121.5 MHz, CDCl₃, 298 K) δ/ppm = 1.2 (broad); **FT-IR** v/cm⁻¹ = 2961 m, 2935 w, 2875 w, 1665 m, 1643 w, 1609 w, 1489 m, 1460 m, 1427 w, 1380 m, 1238 s, 1227 w, 1208 w, 1070 s, 1034 w, 881 m, 849 m, 737 m, 704 m; **UV Vis** (THF) λ/nm = 244, 359 373.

### For comparison: Example 14): Preparation of bis(mesitoyl)phosphinic acid 1,1,3,3-tetra-N-methylguanidinium salt (^{Mes}BAPO-OTMG)

Bismesitoylphosphinic acid (synthesised as described in patent application WO2014095724 A1, 2025 mg, 5.65 mmol) was dissolved in absolute EtOH (30 mL) and 1,1,3,3-tetramethylguanidine (723 µL, 664 mg, 5.76 mmol, 1.02 eq.) was added. The clear yellow solution was evaporated *in vacuo* yielding an off-white solid. The solid was dissolved in boiling DCM. Upon addition of hexane and cooling to -20 °C, the final product was obtained as off-white solid after filtration, washing with Et₂O, and drying *in vacuo* (2389 mg, 5.05 mmol, 89 %).
**¹H NMR** (300 MHz, CDCl₃, 298 K) δ/ppm = 8.24 (bs, 2H, C=N*H*₂⁺), 6.69 (s, 4H, m-Mes), 2.70 (s, 12H, C(N(C*H*₃)₂)₂), 2.29 (s, 12H, o-Mes-C*H*₃), 2.13 (s, 6H, p-Mes-C*H*₃); **¹H NMR** (300 MHz, DMSO-d₆, 298 K) δ/ppm = 7.93 (bs, 2H, C=N*H*₂⁺), 6.78 (s, 4H, m-Mes), 2.84 (s, 12H, C(N(C*H*₃)₂)₂), 2.24 (s, 12H, o-Mes-C*H*₃), 2.23 (s, 6H, p-Mes-C*H*₃); **¹³C{¹H} NMR** (75.5 MHz, DMSO-d₆, 298 K) δ/ppm = 226.9 (d, *J*_{PC} = 105.1 Hz, PCO), 160.9 (*C*=NH₂), 140.4 (d, *J*_{PC} = 40.0 Hz, ipso-Ph), 137.1 (o-Mes), 133.8 (p-Mes), 127.6 (m-Mes), 39.8 (C(N(*C*H₃)₂)₂), 20.6 (p-Mes-C*H*₃), 19.1 (o-Mes-C*H*₃); **³¹P NMR** (121.5 MHz, CDCl₃, 298 K) δ/ppm = 1.42 (s); **³¹P NMR** (121.5 MHz, DMSO-d₆, 298 K) δ/ppm = 3.20 (s); **FT-IR** v/cm⁻¹ = 2927 w, 1671 m, 1653 w, 1589 w, 1570 m, 1452 m, 1433 w, 1419 w, 1405 w, 1380 w, 1228 s, 1145 w, 1096 w, 1071 s, 1032 m, 961 w, 921 w, 885 w, 849 m, 811 m, 727 m, 701 w, 692 m, 622 w.

### II Applications of and tests with compounds of formula (I)

### Example 15): Solubility test of ^{Ph}BAPO-ONBu₄ and ^{Mes}BAPO-ONBu₄

To determine the solubility, small samples of the respective substance were exactly weighed to Eppendorf tubes. Upon shanking at an Eppendorf thermomixer (25 C @ 1400 rpm), water is added until the whole samples was homogenously dissolved.

While ^{Mes}BAPO-ONBu₄_shows only limited solubility in water (3.5 g/l @ 25°C) the inventive ^{Ph}BAPO-ONBu_{4_}has a far superior solubility of 17.2 g/l @ 25°C.

### Example 16): Stability test of ^{Ph}BAPO-ONBu₄ against hydrolysis

To determine the stability of ^{Ph}BAPO-ONBu₄ against hydrolysis, 10 mg were dissolved in 0.6 mL of D₂O in a NMR tube protected from light. To provide an external standard for integration, a sealed capillary with triphenylphosphate (TPP) in C₆D₆ was added. ³¹P NMR spectra have been repeatedly recorded over 84 days and the signal integrals of ^{Ph}BAPO-ONBu₄ relative to the TPP signal integrals have been taken from the NMR spectra (see table 1). Plotting the integrals against the t = 0 value and exponential fitting of the decay (y = e^{-x/t1}, t1 = 74.2±1.8 d, T_{1/2} = ln(2)×t1 = 51.4±1.2 d, adj. R² = 0.997) unveiled a half time of 51 days for ^{Ph}BAPO-ONBu₄ which shows its good stability against hydrolysis.

**Table 1: Integrals of ³¹P NMR signals of ^{Ph}BAPO-ONBu₄ relative to TPP as external standard for integration over time.**

| t/d | integral rel. to TPP | integral rel. to t = 0 |
|---|---|---|
| 0 | 4.24 | 1 |
| 4 | 4.02 | 0.94811 |
| 5 | 4.02 | 0.94811 |
| 14 | 3.46 | 0.81604 |
| 29 | 2.98 | 0.70283 |
| 56 | 1.98 | 0.46698 |
| 84 | 1.31 | 0.30896 |

### Example 17): UV-Vis spectra and photobleaching of ^{Ph}BAPO-ONBu₄ versus ^{Mes}BAPO-ONBu₄

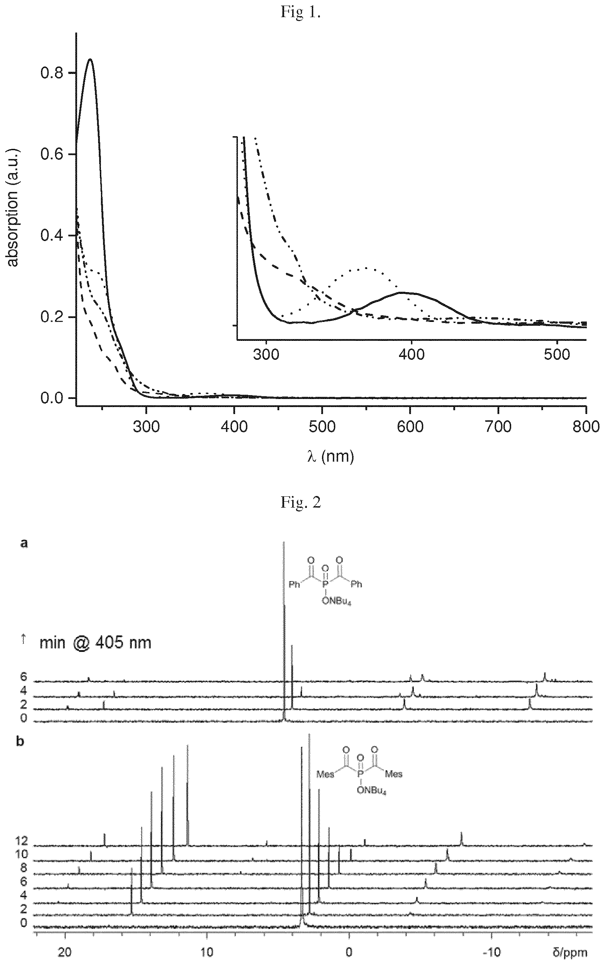

The absorption spectra of ^{Ph}BAPO-ONBu₄ and ^{Mes}BAPO-ONBu₄ prior to irradiation have been determined (see Fig. 1). To compare photobleaching, 0.25 mM solutions of ^{Ph}BAPO-ONBu₄ and ^{Mes}BAPO-ONBu₄ were prepared in THF. UV-Vis spectra were recorded in 2 mm quartz cuvettes prior and after 15 min of irradiation with 265 nm (Lumos 43 LED reactor, Atlas Photonics). Spectra have been smoothed (adjacent averaging, points of window: 5).

The UV-Vis spectra clearly show that the longest wave absorption, λₘₐₓ, which corresponds to the η-π* transition of the C=O groups and is responsible for the photoactivity of ^{Ph}BAPO-ONBu₄ (λₘₐₓ = 394 nm) is red shifted by about 20 nm compared to the substituted derivative ^{Mes}BAPO-ONBu₄ (λₘₐₓ = 373 nm). This allows to use light of lower energy as provided by standard LED lamps which represents a significant technical and commercial advantage.

Rapid and quantitative photobleaching, i.e. the formation of colourless photoproducts, is one of the superior properties of bisacylphosphinoxide photoinitiators in general and is a significant advantage over other frequently applied compounds such as α-hydroxy ketones. As Fig 1 shows, a feast decay of the long wave absorption bands upon UV/Vis irradiation proves that upon photolysis ^{Ph}BAPO-ONBu₄ rapidly undergoes Norrish-type I cleavage reactions and only colourless photoproducts are formed. This makes novel ^{Ph}BAPO-ONBu₄ likewise particularly suitable inter alia for free radical polymerisations in aqueous phase, clear coatings and powder coatings. Details are given in Table 3.

**Table 2. Molar extinction coefficients of ^{Ph}BAPO-ONBu₄ and ^{Mes}BAPO-ONBu₄ at various wave lengths λ**

| ^{Ph}BAPO-ONBu₄ | | | ^{Mes}BAPO-ONBu₄ | | |
|---|---|---|---|---|---|
| λ/ nm | ε/ Lmol⁻¹cm⁻¹ | adj. R² | λ/ nm | ε/ Lmol⁻¹cm⁻¹ | adj. R² |
| 235 | 16957±1372 | 0.974 | 244 | 5935±72 | 0.999 |
| 394 | 171±4 | 0.997 | 359 | 211±3 | 0.999 |

**Table 3. Molar extinction coefficients of ^{Ph}BAPO-ONBu₄ and ^{Mes}BAPO-ONBu₄ at relevant LED wavelengths.**

| | ^{Ph}BAPO-ONBu₄ | | ^{Mes}BAPO-ONBu₄ | |
|---|---|---|---|---|
| λ/ nm | ε/ Lmol-¹cm⁻¹ | adj. R² | ε/ Lmol⁻¹cm⁻¹ | adj. R² |
| 265 | 3424±88 | 0.996 | 3368±88 | 0.997 |
| 365 | 106±2 | 0.998 | 216±4 | 0.999 |

The results are further illustrated by Fig. 1

### Example 18): Photoactivity of ^{Ph}BAPO-ONBu₄ versus ^{Mes}BAPO-ONBu₄

The photoactivities of the phenyl and the mesityl derivative have been determined upon irradiation with an LED at 405 nm (Lumos 43 LED reactor, Atlas Photonics) in CD₃CN (80 mM BAPO) in the presence of diphenyl disulfide (3 eq.) as radical scavenger. The photolysis has been followed by ³¹P NMR. Figure 2 clearly shows that the phenyl derivative ^{Ph}BAPO-ONBu₄ is completely photolyzed within 6 min while the signal of mesityl derivative ^{Mes}BAPO-ONBu₄requires over 12 min irradiation time to vanish completely. Hence, ^{Ph}BAPO-ONBu₄ can be regarded as at least twice as photoactive as ^{Mes}BAPO-ONBu₄ upon 405 nm irradiation. This is in excellent accordance with the stronger molar extinction coefficient of the phenyl vs. the mesityl derivative at 405 nm disclosed in example 17) above ^{Ph}BAPO-ONBu₄: ε₄₀₅ = 154 Lmol⁻¹cm⁻¹, ^{Mes}BAPO-ONBu₄: ε₄₀₅ = 64 Lmol⁻¹cm⁻¹). The results are further illustrated by Fig. 2

### Example 19): Surfactant free emulsion polymerization of styrene with ^{Ph}BAPO-ONBu₄ as photoinitiator

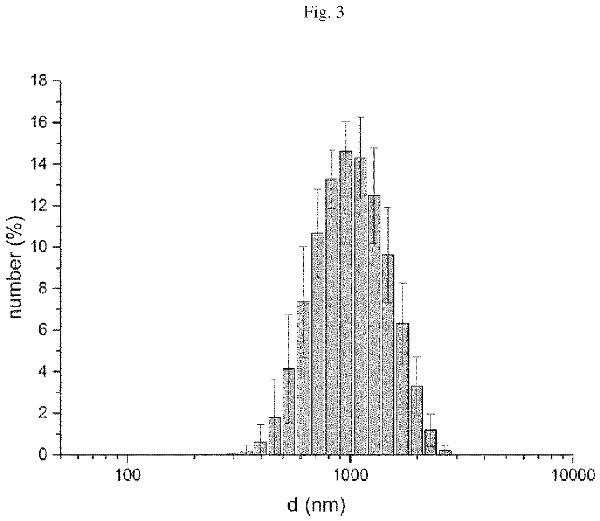

^{Ph}BAPO-ONBu₄ (46 mg, 0.089 mmol, 2 mol-% according to styrene) and deionized water (10 mL) were stirred in a glass vial until the photoinitiator was completely dissolved. The mixture was degassed for 5 min with argon while stirring. After addition of styrene (0.5 mL, 4.4 mmol, filtered over neutral alumina to remove stabilizer), the mixture was again degassed for 5 min while stirring. The suspension was subsequently irradiated for 30 min in a blue LED reactor (465 nm) under vigorous stirring. A milky white dispersion is obtained. DLS (Dynamic Light Scattering) of a ten-fold diluted sample unveiled the presence of polystyrene particles of 400 to 2600 nm size with a maximum in the size distribution at 950 nm, see Fig. 3.

## Claims

1. Compounds of formula (I): 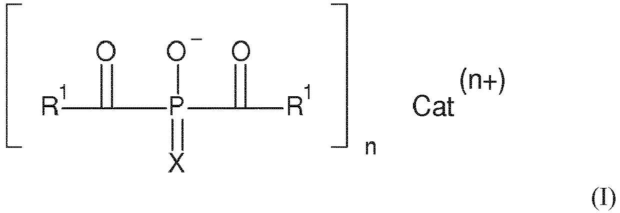 wherein
**X** is oxygen or sulfur, preferably oxygen
**n** is an integer of 1 or more, preferably 1 to 6, more preferably 1,2 or 3, and even more preferably 1
**Cat⁽ⁿ⁺⁾** is an n-valent cation and
the substituents **R¹** are independently, preferably identically selected from those of formulae (IIa) and (IIb) 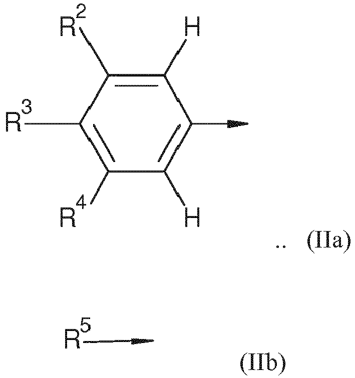 wherein
the arrows indicate the bond to the carbonyl function depicted in formula (I) and
in formula (IIa)
R², R³ and R⁴ are independently selected from the group consisting of hydrogen, halogen, -NO₂, -CN, -SO₂N(R⁶)₂, -NR⁶SO₂R⁷, -(NR⁶)₂, -COR⁷, -O(CO)R⁶, -(CO)OR⁷, -O(CO)OR⁷, -NR⁶(CO)N(R⁶)₂, -NR⁶(CO)R⁷, -(CO)N(R⁶)₂, -NR⁶(CO)OR⁷, -O(CO)N(R⁶)₂, -Si(R⁷)₃, -OSi(R⁷)₃, Si(OR⁷)_{y}(R⁷)_{3-y}, -OSi(OR⁷)_{y}(R⁷)_{3-y} with y = 1, 2 or 3, -SO₃M, -COOM,-PO₃M₂, -PO(N(R⁶)₂)₂, -PO(OR⁷)₂, -N(R⁶)₃⁺An⁻, heterocyclyl, alkyl, alkoxy, alkyl-thio, alkenyl, alkenoxy, alkene-thio, aryl, aryloxy, aryl-thio or two substituents together are aryldiyl, alkanediyl or alkenediyl, alkanedioxy, alkaneoxy, alkenedioxy, alkeneoxy
whereby the alkyl, alkoxy, alkyl-thio, alkenyl, alkenoxy, alkene-thio, alkanediyl or alkenediyl, alkanedioxy, alkaneoxy, alkenedioxy, alkeneoxy substituents are
• either not, once, twice or more than twice interrupted by non-successive functional groups selected from the group consisting of:
-O-, -S-, -SO₂-, -SO-, -SO₂NR⁶-, -NR⁶SO₂-, -NR⁶-, -CO-, -O(CO)-, -(CO)O-, -O(CO)O-, -NR⁶(CO)NR⁶-, -NR⁶(CO)-, -(CO)NR⁶-, -NR⁶(CO)O-, -O(CO)NR⁶-, -Si(R⁷)₂-, -OSi(R⁷)₂-, OSi(R⁷)₂O-, -Si(R⁷)₂O-,
and
• either not, once, twice or more than twice interrupted by bivalent residues selected from the group consisting of heterocyclo-diyl, and aryldiyl,
and
• either not, once, twice or more than twice substituted by substituents selected from the group consisting of:
halogen, -CN, C₆-C₁₄-aryl, C₁-C₈-alkoxy, C₁-C₈-alkylthio, - SO₃M, -COOM, -PO₃M₂, -PO(N(R⁶)₂)₂, -PO(OR⁷)₂, -SO₂N(R⁶)₂, -N(R⁶)₂, -CON(R⁷)₂, -COR⁶, -OCOR⁷, -NR⁶(CO)R⁷, -(CO)OR⁶,-NR⁶(CO)N(R⁶)₂, -Si(OR⁷)_{y}R⁷)_{3-y}, -OSi(OR⁷)_{y}(R⁷)_{3-y} with y = 1, 2 or 3 and -N(R⁶)₃⁺An⁻, and
in formula (IIb)
R⁵ is alkyl being
• either not, once, twice or more than twice interrupted by non-successive functional groups selected from the group consisting of:
-O-, -S-, -SO₂-, -SO-, -SO₂NR⁶-, -NR⁶SO₂-, -NR⁶-, -CO-, -O(CO)-, -(CO)O-, -O(CO)O-, -NR⁶(CO)NR⁶-, -NR⁶(CO)-, -(CO)NR⁴-, -NR⁴(CO)O-, -O(CO)NR⁶-, -Si(R⁷)₂-, -OSi(R⁷)₂-, -OSi(R⁷)₂O-, -Si(R⁷)₂O-,
and
• either not, once, twice or more than twice interrupted by bivalent residues selected from the group consisting of heterocyclo-diyl, and aryldiyl,
and
• either not, once, twice or more than twice substituted by substituents selected from the group consisting of:
alkyl-thio, aryloxy, halogen, -CN, C₆-C₁₄-aryl, C₁-C₈-alkoxy, C₁-C₈-alkylthio, -SO₃M, -COOM, -PO₃M₂, -PO(N(R⁶)₂)₂, -PO(OR⁷)₂, -SO₂N(R⁶)₂, -N(R⁶)₂, -CON(R⁷)₂, -COR⁶, -OCOR⁷, -NR⁶(CO)R⁷, -(CO)OR⁶, -NR⁶(CO)N(R⁶)₂, -Si(OR⁷)_{y}(R⁷)_{3-y}, -OSi(OR⁷)_{y}(R⁷)_{3-y} with y = 1, 2 or 3 and -N(R⁶)₃⁺An⁻
whereby in all formulae where used
R⁶ is independently selected from the group consisting of hydrogen, C₁-C₈-alkyl, C₆-C₁₄-aryl, and heterocyclyl or N(R⁶)₂ as a whole is a N-containing heterocycle,
R⁷ is independently selected from the group consisting of C₁-C₈-alkyl, C₆-C₁₄-aryl, and heterocyclyl or N(R⁶)₂ as a whole is a N-containing heterocycle
M is hydrogen, or 1/q equivalent of an q-valent metal ion or is an ammonium ion or a guanidinium ion or a primary, secondary, tertiary or quaternary organic ammonium ion, in particular those of formula [N(C₁-C₁₈-alkyl)ₛHₜ]⁺ wherein s is 1,2, 3 or 4 and t is (4-s) and
An⁻ is 1/p equivalent of a p-valent anion.

2. Compounds according to claim 1, wherein in formula (I)
**n** is 1 and
**Cat⁽ⁿ⁺⁾** is selected from the group consisting of hydrogen, lithium, sodium, potassium, ammonium, guanidinium, a primary, secondary, tertiary or quaternary ammonium ion, in particular those of formula [N(C₁-C₁₈-alkyl)ₛHₜ]⁺ wherein s is 1, 2, 3 or 4 and t is (4-s), guanidinium that is once, twice, three times or four times N-substituted with s (C₁-C₁₈-alkyl) or heterocyclylium.

3. Compounds according to claim 1 or 2, wherein in formula (I)
**n** is 1 and
**Cat⁽ⁿ⁺⁾** is selected from the group consisting of hydrogen, lithium, sodium, potassium, quaternary ammonium of formula [N(C₁-C₄-alkyl)₄]⁻ and tetramethyl-guanidinium or di-N(C₁-C₈-alkyl)-imidazolium.

4. Compounds according to anyone of claims 1 to 3, wherein in formula (I) the substituents **R¹** are those of formula (IIb), preferably those selected from the group consisting of C₁-C₁₈-alkyl which is
• either not, once, twice or more than twice interrupted by non-successive functional groups selected from the group consisting of:
-O-, -O(C=O)-, -(C=O)-
and are
• either not, once, twice or more than twice substituted by substituents selected from the group consisting of:
fluoro, chloro, phenyl.

5. Compounds according to anyone of claims 1 to 4, wherein in formula (I) the substituents **R¹** are those of formula (IIa), preferably those wherein the substituents R², R³ and R⁴ are selected from the group consisting of hydrogen, fluoro, chloro, bromo, -NO₂, -CN, -SO₂N(R⁶)₂, -(NR⁶)₂, -(CO)OR⁷, -(CO)N(R⁶)₂, -NR⁶(CO)R⁷, alkyl, alkenyl and alkoxy
whereby the alkyl and alkoxy substituents are
• either not, once, twice or more than twice interrupted by non-successive functional groups selected from the group consisting of:
-O-, -O(C=O)-, -(C=O)-
and are
• either not, once, twice or more than twice substituted by substituents selected from the group consisting of:
fluoro, chloro, -CN and phenyl
whereby in all formulae where used
R⁶ is independently selected from the group consisting of hydrogen, C₁-C₄-alkyl, phenyl
R⁷ is independently selected from the group consisting of C₁-C₄-alkyl or phenyl.

6. Compounds according to claim 5, wherein for substituents **R¹** at least one of R², R³ and R⁴ is hydrogen, preferably at least R² and R⁴.

7. Compounds according to claim 5 or 6, wherein at least one of substituents R², R³ and R⁴ are selected from the group consisting of hydrogen, fluoro, chloro, bromo, -NO₂, -CN, -(CO)OR⁷, -(CO)N(R⁶)₂, alkyl and alkoxy
whereby the alkyl and alkoxy substituents are
• either not, once, twice or more than twice interrupted by non-successive functional groups selected from the group consisting of:
-O-, -O(C=O)-, -(C=O)-
and are
• either not, once, twice or more than twice substituted by substituents selected from the group consisting of:
fluoro, chloro, -CN and phenyl
whereby in all formulae where used
R⁶ is independently selected from the group consisting of hydrogen, C₁-C₄-alkyl, phenyl
R⁷ is independently selected from the group consisting of C₁-C₄-alkyl or phenyl.

8. Compounds according to anyone of claims 5 to 7, wherein at least one of substituents R², R³ preferably at least R² and R⁴ are hydrogen.

9. A process for the preparation of compounds according to anyone of claims 1 to 8 comprising at least the step of oxidizing compounds of formula (IVa) or (IVb) to compounds of formula (I) 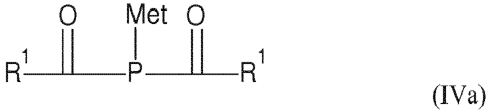 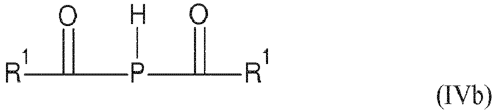 whereby in formula (IVa), and (IVb)
R¹ has the same meaning as defined for formula (I) in anyone of claims 1 to 8.

10. A process for the preparation of compounds according to anyone of claims 1 to 8 comprising at least the steps of
A) reacting phosphinic acid (H₃PO₂) with compounds of formula (IX), 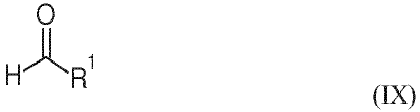 wherein R¹ has the same meaning as defined for formula (I) in anyone of claims 1 to 10 to obtain compounds of formula (X) 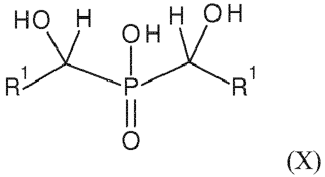 and
B) oxidizing the alcohol functionalities in compounds of formula (X) to obtain compounds of formula (I).

11. Use of compounds according to anyone of claims 1 to 8 as photoinitiators.

12. Photo-curable compositions comprising
I) at least one ethylenically unsaturated compound and
II) at least one compound according to anyone of claims 1 to 8.

13. Photo-curable compositions according to claim 12 further comprising one or more further ingredients selected from the group consisting of:
• water
• polar diluents or solvents such as ethers like ethylenglycol dimethylether and polyethyleneglycol ethers
• organic or inorganic pigments
• UV-adsorbers
• inorganic fillers
• stabilizer
• isocyanates and/or polyisocyanates
• flattening agents
• matting agents,
• defoamer
• anti-friction agents such as silicon containing antifriction agents,
• surfactants
• resins such as formaldehyde resins, polyurethan resins, polyacrylates, polymethacrylates, polyacrylamides, polymethacrylamides, polyvinylethers, cellulosic resins and sucrose benzoate
• further photoinitiators, including but not limited to Norrish Type I initiators such as 2-hydroxy-1-{4-[4-(2-hydroxy-2-methyl-propionyl)-benzyl]-phenyl}-2-methyl-propan-1-one (Irgacure 127), 2-hydroxy-1-[4-(2-hydroxyethoxy)-phenyl]-phenyl]-2-methylpropan-1-one (Irgacure 2959), 1-hydroxy-cyclohexyl-phenyl-ketone (Irgacure 184), 2-hydroxy-2-methyl-1-phenyl-1-propanone (Irgacure 1173), benzildimethylketal and oligo[2-hydroxy-2-methyl-1-[4-(1-methylvinyl)phenyl]propanone] (Esacure KIP 150 from Lamberti) as well as mono- or bisacylphosphinoxides.

14. Process for preparing a cured composition by exposing a photo-curable composition according to claims 12 or 13 to electromagnetic radiation, preferably ultraviolet or blue-light radiation.

15. The cured compositions obtainable by a process according to claim 14.
